(19) Europäisches Patentamt
European Patent Office
Office européen des brevets

(11) **EP 1 790 015 B1**

(12) **EUROPÄISCHE PATENTSCHRIFT**

(45) Veröffentlichungstag und Bekanntmachung des Hinweises auf die Patenterteilung:
**27.02.2008 Patentblatt 2008/09**

(21) Anmeldenummer: **05785176.8**

(22) Anmeldetag: **07.09.2005**

(51) Int Cl.:
*H01L 31/042* (2006.01)     *H01L 27/142* (2006.01)
*H01L 31/05* (2006.01)     *H01L 31/18* (2006.01)
*H01L 31/02* (2006.01)

(86) Internationale Anmeldenummer:
**PCT/EP2005/009600**

(87) Internationale Veröffentlichungsnummer:
**WO 2006/027225 (16.03.2006 Gazette 2006/11)**

(54) **SOLARZELLENANORDNUNG SOWIE VERFAHREN ZUM VERSCHALTEN EINES SOLARZELLENSTRINGS**

SOLAR CELL ASSEMBLY AND METHOD FOR CONNECTING A STRING OF SOLAR CELLS

ENSEMBLE CELLULE SOLAIRE ET PROCEDE POUR LA CONNEXION D'UNE CHAINE DE CELLULES SOLAIRES

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **11.09.2004 DE 102004044061**

(43) Veröffentlichungstag der Anmeldung:
**30.05.2007 Patentblatt 2007/22**

(73) Patentinhaber: **AZUR SPACE Solar Power GmbH 74072 Heilbronn (DE)**

(72) Erfinder:
• **HILGARTH, Just 74360 Ilsfeld (DE)**
• **POECK, Dieter 20146 Hamburg (DE)**
• **UEBELE, Paul 74199 Untergruppenbach (DE)**

(74) Vertreter: **Stoffregen, Hans-Herbert Patentanwalt Dipl.-Phys. Dr. Hans-Herbert Stoffregen Friedrich-Ebert-Anlage 11 b D-63450 Hanau (DE)**

(56) Entgegenhaltungen:
EP-A- 0 984 496     WO-A-03/012880
US-A- 4 481 378     US-A1- 2004 040 593

• **TAYLOR S J ET AL: "Shadow protection for tandem solar cells in space" SOLAR ENERGY MATERIALS AND SOLAR CELLS, ELSEVIER SCIENCE PUBLISHERS, AMSTERDAM, NL, Bd. 66, Nr. 1-4, Februar 2001 (2001-02), Seiten 567-571, XP004224722 ISSN: 0927-0248**

**Beschreibung**

Die Erfindung bezieht sich auf eine Solarzellenanordnung umfassend zumindest eine erste Solarzelle mit zwischen Front- und Rückkontakt verlaufenden photoaktiven Halbleiterschichten sowie zumindest eine mit der Solarzelle verbundene diskrete Schutzdiode mit einem aus Halbleitermaterial einer ersten Leitfähigkeit bestehenden Substrat, in einem Oberflächenbereich des Substrats ausgebildeter Schicht oder auf den Oberflächenbereich aufgetragener Schicht zweiter Leitfähigkeit, einen ersten metallischen Kontakt auf der Schicht der zweiten Leitfähigkeit und einen auf dem Substrat angeordneten zweiten metallischen Kontakt, wobei von dem ersten und dem zweiten metallischen Kontakt Verbinder zum Verschalten der Schutzdiode ausgehen. Ferner bezieht sich die Erfindung auf ein Verfahren zum Verschalten eines Solarzellenstrings.

Der Schwerpunkt der Halbleiter-Solarzellen-Fertigung tendiert aufgrund der wesentlich höheren Wirkungsgrade in der Umwandlung von Sonnenlicht in Strom speziell bei Raumfahrtzellen von dem preiswerten Silizium zu den im Material und in der Herstellung wesentlich teureren III-V-Halbleiter-Solarzellen (III = Elemente der III. Gruppe des Periodensystems wie Ga oder In; V = Elemente der V. Gruppe des Periodensystems wie As oder P).

Bei den entsprechenden Solarzellen erfolgt die Herstellung der photoaktiven Schichten in einem aufwendigen kristallinen Aufwachsprozess (Epitaxie), durch Abscheiden meist einer Vielzahl von unterschiedlichen Schichten einkristallin meist auf einer im Vergleich zu Silizium sehr teuren einkristallinen Germanium-Scheibe (Ge-Substrat wafer). Diese Epitaxie-wafer enthalten nach der Schichtabscheidung alle zur Umwandlung des Sonnenlichts erforderlichen Elemente. Sie werden nach ihrer Herstellung dann mit in der Halbleitertechnologie üblichen photolithographischen Verfahren und Ätzen, Metallisierungs- und Antireflexions-Bedampfen etc. zu Solarzellen weiterbearbeitet und letztendlich aus der Scheibe geschnitten.

Durch geeignete Wahl der Schichten und ihrer Zusammensetzung aus verschiedenen III-V-Materialien können hierbei für unterschiedliche Wellenlängen des Lichts unterschiedlich empfindliche Schichtenfolgen übereinander abgeschieden werden und zu sogenannten "Multi-junction"-Solarzellen verarbeitet werden, was den hohen Wirkungsgrad der Zellen mit erklärt. Der aktuelle Stand der Anwendung sind Triple-Zellen, d. h. drei übereinander geschichtete Sub-Zellen, wobei zwei epitaktisch gewachsen aus III-V-Material bestehen und die dritte aus dem aktiv gemischten Ge-Substrat besteht. Üblicherweise werden z. Zt. III-V-Solarzellen aus runden wafern (Substraten) von 100 mm Durchmesser (4"-wafer) gefertigt.

Eine Triple-Zelle ist eine Dreifachzelle mit drei übereinander geschichteten seriell verbundenen Solarzellen (3 Zellen (Sub-Zellen) mit unterschiedlicher spektraler Empfindlichkeit zur Erhöhung des Gesamtwirkungsgrads der Triple-Zelle; "Multi-junction," Zelle: Zelle mit mehreren Sub-Zellen).

Entsprechende multi-junction-Solarzellen in Form von Triple-Zellen können z. B. aus einer auf dem Ge-Substrat ausgebildeten Ge-Bottom-Zelle, einer GaInAs-Mittelzelle und einer GaInP-Topzelle bestehen.

Der Preis der Epitaxie-wafer beträgt aktuell mehr als das 20-fache des Preises eines Silizium-wafers gleicher Größe zur Herstellung von Silizium- Solarzellen. Aufgrund des hohen Preises des Ausgangsmaterials in Form der Epitaxie-wafer zur Herstellung von III-V-Solarzellen sollte zur Reduzierung des Ausfalls durch den Solarzellen-Herstellungsprozess die Anzahl der Prozessschritte möglichst gering gehalten werden, um dadurch eine weitere Kostensteigerung des Endpreises der Zelle zu vermeiden.

Wegen des größeren spezifischen Gewichts der III-V-Verbindungen und des Germaniums verglichen mit Silizium (ca. Faktor 4) und der hohen Transportkosten von Satelliten ins All sind die III-V-Scheiben dünner als in der Standard-Halbleitertechnologie (z.B. IC-Fertigung) üblich, wodurch das Ausfallrisiko bei erhöhtem Fertigungsaufwand noch gesteigert ist, zumal die Ge-Substrate auch wesentlich brüchiger sind als Si-wafer.

Um den Aufwand zur Verbindung der Zellen zu strings (Einheit der seriell verschalteten Solarzellen zu der auf einem panel gewünschten Betriebsspannung; panel = Paneele; mit Solarzellen bestückte Fläche (Flügel) wie bei Satelliten üblich) möglichst gering zu halten, aber auch um nicht zu kurze strings zu erhalten, da die Betriebsspannung der modernen III-V-Zellen ein Vielfaches der Si-Zellen beträgt, sind verhältnismäßig große Zellen erwünscht. Gleichzeitig macht der hohe Preis der Epitaxie-wafer es wünschenswert, möglichst viel Fläche des wafers für die Zellen zu nutzen. Aus Kostengründen sind daher Zellen von ca. 8 cm x 4cm mit zwei abgeschnittenen Ecken (sogenannte cropped corner cells) üblich geworden, wobei aus einem 4"-wafer zwei Zellen erhalten werden. Durch das Abschneiden der Ecken kann dadurch ein größerer Anteil der wafer-Fläche für die Zelle als bei rein rechteckigen Zellen genutzt werden.

Bei einem als qualitativ nicht ausreichendem Scheibenrand von 2 mm Breite, einer Scheibe von 100 mm Durchmesser ergibt sich eine Fläche von 72,4 cm$^2$. Zwei rechteckige Zellen können maximal eine Fläche von 6,79 cm x 6,79 cm =46,1 cm$^2$ (64 %) erreichen, während sich bei zwei Zellen von 8 cm x 4 cm Kantenlänge mit abgeschnittenen Ecken von z. B. 1,35 cm eine Fläche von 60,34 cm$^2$ ergibt, so dass 83 % der Scheibenfläche genutzt werden kann. Durch die Geometrie bedingt füllen diese Zellen die Fläche eines panels nicht vollständig aus: an den Ecken zwischen den Zellen verbleibt eine nicht zur Lichtumwandlung genutzte dreieckige Fläche.

Bei großflächigen Halbleiter-Dioden, wie diese die Solarzellen bilden, sind hochohmige, lokale, kleindimensionierte elektrische Verbindungen über den p/n-Übergang des Halbleitermaterials (Mikro-Kurzschlüsse), wie sie z. B.

durch Oberflächenverletzungen während der Herstellung oder besonders bei epitaxierten p/n-Übergängen wie bei 111-V-Solarzellen durch Dotierstoffanhäufungen (entartetes Halbleitermaterial) z. B. an Kristallstörungen (z. B. Verletzungen aufgrund geringfügig abweichendem Kristallgitter) entstehen, oft unvermeidlich. Diese Mikro-Kurzschlüsse, die die Funktion der Diode als Solarzelle (p/n-Übergang in Flussrichtung) nicht oder nur sehr gering mindern, können im string bei Betrieb der Zelle in Sperrrichtung bekanntermaßen zur Zerstörung der Zelle führen. Bei sperrendem p/n-Übergang kann der Solarstrom von der hohen string-Spannung $U_s$ mit der Leistung $N = U_s \cdot I_s$ durch die hochohmigen Mikro-Kurzschlüsse gepresst werden. Dies kann lokal zur starken Erhitzung, Umdotierung zur Niederohmigkeit (starke Entartung des Halbleiters) und letztlich zur Zerstörung der Zelle führen.

Schutz gegen diese Zerstörung bewirkt eine sog. Bypass- oder Schutzdiode, d. h. eine antiparallel mit dem p/n-Übergang der abgeschatteten Zelle verbundene Diode, die, wenn der p/n-Übergang der Zelle sperrt, in Flussrichtung gepolt ist und den Strom bei einer Spannung Ud, die der Kennlinie dieser Diode in Flussrichtung bei eben diesem Strom entspricht, durchlässt. Die Spannung Ur an den Enden des strings wird vermindert durch die fehlende Spannung Um der Zelle und die Flussspannung der Diode -Ud: Ur = Us-Um-Ud. Im nicht abgeschatteten Zustand der Zelle sperrt der p/n-Übergang der Schutzdiode den Stromfluss durch dieselbe bei einer Sperrspannung, die lediglich der Flussspannung der zugehörigen Solarzelle entspricht.

Die Verwendung von Schutzdioden für die Zellen zur Verhinderung der Zerstörung einzelner Zellen im string bei Abschattung in Form von antiparallel elektrisch mit den Zellen verbundenen Dioden, ist an sich bekannt.

Für III-V-Zellen existieren als Lösung monolithisch integrierte Schutzdioden (monolithische Dioden), d. h. Dioden, die aus ähnlichen Elementen wie die Zellen schon während der Herstellung der Epitaxie direkt auf dem wafer in meist zusätzlichen Prozessschritten hergestellt werden und in zusätzlichen Technologieschritten beim Herstellen der Zellen zu solchen verarbeitet werden, und sich dann auch auf den Zellen befinden (s. z. B. DE-A- 3 826 721, US-A-2002/0179141).

Ein grundsätzlicher Nachteil dieser Lösungen besteht darin, dass die aktive Fläche der Zelle reduziert wird. Die Schutzdioden werden im Allgemeinen daher möglichst klein in ihrer Dimension gewählt. Hierdurch wird ihre Spannung bei Stromfluss und damit ihre Leistung erhöht. Dies kann zu ihrer Zerstörung auf lange Sicht oder - da die Schutzdiode Teil der Zelle ist - lokal zu unerwünschter starker Erwärmung derselben führen.

Da monolithische Dioden einen zusätzlichen Aufwand sowohl auf wafer-Ebene, d. h. zusätzliche Epitaxie-Schichten und zusätzliche technologische Prozesse bei der Herstellung der Zellen erfordern, bilden diese einen nicht zu vernachlässigenden zusätzlichen Kostenfaktor. Da die monolithischen Dioden nur aus gitterangepassstem III-V-Material bestehen können, ist auch nur eine geringe Freiheit der Wahl des Typs der Diode (nur III-V-Dioden mit hoher Flussspannung) möglich.

Daher wäre eine diskrete Diode, die unabhängig von der Fertigung der Zelle herstellbar ist und somit auch mehr materielle Freiheit bietet, vorzuziehen. Diese hätte zusätzlich den Vorteil, unabhängig von der Zelle ausgewählt und geprüft zu werden, so dass eine schon während der Herstellung schadhaft gewordene Diode nicht gleichzeitig eine teure unbrauchbare Zelle bedeutet.

Die Anbringung diskreter Dioden an die Solarzellen als Alternative zu den monolithisch integrierten Schutzdioden erfordert von den Herstellern von Solar-Flügeln (panels) im Allgemeinen zusätzlichen Aufwand bei der Anbringung. Dies trifft insbesondere bei rechteckigen Solarzellen zu, die die Fläche des Flügels vollständig ausfüllen, so dass zur Anbringung der Schutzdioden in die dritte Dimension (Zuleitungen und Diode unterhalb der Zellen) ausgewichen werden muss. Dies bedeutet einen hohen Aufwand in der panel-Herstellung. Außerdem würde sich das Gewicht des Flügels durch die zusätzlich notwendigen langen Zuleitungskabel erhöhen.

Der US-A-4,481,378 ist ein Solarzellenmodul mit seriell verschalteten Solarzellen und Schutzdioden zu entnehmen, wobei jeweils eine Schutzdiode antiparallel mit je einer Zelle verbunden ist. Die Schutzdioden sind mit den Rückseiten benachbarter Zellen verbunden und in den Zwischenräumen zwischen den Solarzellen angeordnet.

Nach der US-B-6,563,289 wird von einer ursprünglich rechteckigen Solarzelle eine Ecke abgetrennt und als Schutzdiode entgegengesetzt gepolt mit der Solarzelle verbunden.

Eine Solarzellenanordnung nach der EP-A-0 984 496 (US-B-6,353,176) umfasst Solarzellen mit ausgesparten Ecken, in denen Schutzdioden anordbar sind. Die Schutzdioden selbst sind abgetrennte Ecken der ursprünglich rechteckigen Solarzellen. Der p/n-Übergang der Diode liegt zwischen Vorder- und Rückseite.

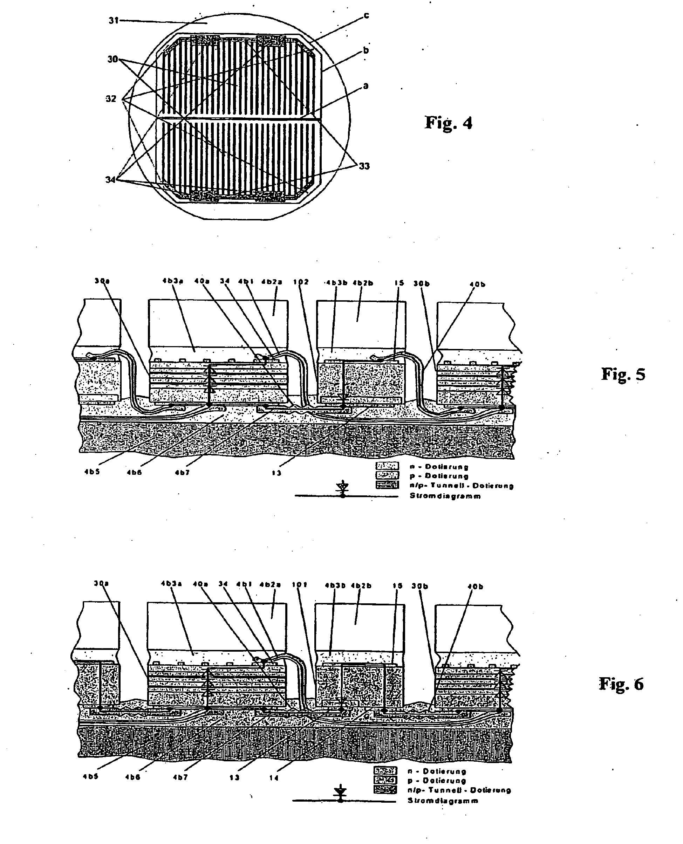

Die WO-A-03/012880 schlägt eine Solarzelle mit integraler Schutzdiode vor, die im Ausführungsbeispiel der Fig. 5 als Schottky-Diode ausgebildet ist.

Eine Solarzellenanordnung mit Strombegrenzungsschutz gemäß US-B-6,034,322 umfasst rechteckige Solarzellen mit einer angeschrägten Kante an einer Ecke, in die eine dreieckige Diode zum Schutz der Solarzelle anordbar ist. Als Verbinder werden solche eingesetzt, die in der Ebene der Solarzellen eine Bewegung zulassen.

Nach der US-A-2003/0029494 werden Schutzdioden in einem Solarzellenstring integriert, wobei ein Verbinder von der Vorderseite der Schutzdiode zur Rückseite einer benachbarten Solarzelle führt, die mit der Vorderseite der zu schützenden Solarzelle seriell im string verbunden ist. Der Rückseitenkontakt der Schutzdiode führt zur Rückseite der zu schützenden Zelle.

Der vorliegenden Erfindung liegt die Aufgabe zu Grunde, eine Solarzellenanordnung der zuvor beschriebenen Art so weiterzubilden, dass im hinreichenden Umfang eine Solarzelle bzw. ein Solarzellenverbund wie string durch eine oder mehrere Schutzdioden geschützt werden kann, ohne dass zwingend auf die Materialien der Solarzellen selbst zurückgegriffen werden muss. Ferner soll eine problemlose Verschaltung zwischen den Schutzdioden und den Solarzellen möglich sein, wobei gleichzeitig eine hohe Gewichtszunahme vermieden werden soll.

Erfindungsgemäß wird die Aufgabe im Wesentlichen dadurch gelöst, dass der zweite Kontakt unmittelbar mit dem Substrat der Schutzdiode kontaktiert und neben dem ersten metallischen Kontakt und zu diesem beabstandet angeordnet und mit dem ersten metallischen Kontakt elektrisch über einen p/n-Übergang verbunden ist. Dabei kann der erste oder der zweite metallische Kontakt mit der Rückseite der zweiten Solarzelle und der dritte metallische Kontakt mit der Frontseite der ersten Solarzelle verbunden sein. Ferner wird die Schutzdiode über den ersten oder zweiten metallischen Kontakt antiparallel zu der ersten Solarzelle über die zweite Solarzelle verschaltet.

Insbesondere wird eine Solarzellenanordnung vorgeschlagen, die eine diskrete Schutzdiode umfasst, die in Bezug auf den frontseitigen Bereich derart strukturiert ist, dass neben dem n/p- bzw. p/n-Übergang der Schutzdiode ein unmittelbarer ohmscher Kontakt zwischen dem zweiten metallischen Kontakt und dem Substrat der Schutzdiode erzeugt wird, um einerseits eine elektrisch leitende Verbindung zwischen Solarzellen zu ermöglichen und andererseits die Schutzdiode antiparallel zu der zu schützenden Solarzelle zu schalten.

Erfindungsgemäß wird die Aufgabe des Schutzes einer Solarzelle im string im Wesentlichen durch eine antiparallel verbundene diskrete Diode gelöst, bestehend aus einem Halbleiterkörper einer ersten Leitungsart (Substrat), bei der auf der Vorderseite neben dem ersten metallischen Kontakt auf einem Halbleiterbereich zweiter Leitungsart, zu diesem beabstandet auf dem Halbleiter erster Leitungsart elektrisch durch den p/n-Übergang getrennt ein zweiter metallischer Kontakt vorgesehen ist, der unmittelbar mit dem Substrat elektrisch verbunden ist. Dabei kann, je nach Art der Solarzelle und Wahl der Leitungsart des Substrats der Diode, über den ersten oder den zweiten Kontakt mittels Verbinder die Rückseite der zu schützenden Solarzelle elektrisch mit der Diode verbunden werden und mit dem zweiten respektive ersten metallischen Kontakt der Diode die Rückseite der der zu schützenden Zelle im string unmittelbar nachfolgenden Zelle verbunden werden, die ihrerseits mittels des Verbinders zum seriellen Verschalten der Solarzellen zum string elektrisch mit der Vorderseite der vorangehenden zu schützenden Zelle verbunden ist, wodurch die Diode im Verbund eine zur zu schützenden Solarzelle antiparallel angeordnete Schutzdiode bildet.

In Weiterbildung ist vorgesehen, dass die erste und zweite Solarzelle über zumindest zwei Schutzdioden verbunden sind, dass ein dritter metallischer Kontakt der einen ersten Schutzdiode sowohl mit dem Rückkontakt der zweiten Solarzelle als auch mit dem zweiten metallischen Kontakt der zweiten Schutzdiode verbunden ist, deren dritter metallischer Kontakt mit dem Frontkontakt der ersten Solarzelle verbunden ist. Somit ergibt sich eine einfache Verschaltung der Solarzellen untereinander bei gleichzeitiger Verschaltung der Schutzdioden zu den zu schützenden Solarzellen.

Bei dem Verbinden von zwei Solarzellen über zwei Schutzdioden kann eine der Schutzdioden derart ausgebildet sein, dass der zweite metallische Kontakt mit dem ersten metallischen Kontakt verbunden ist und dass sich unter dem ersten und dem zweiten metallischen Kontakt der Oberflächenbereich der zweiten Leitfähigkeit erstreckt.

Um ein einfaches Verbinden der von der ersten und zweiten Schutzdiode ausgehenden und diese miteinander zu verbindenden Verbindern zu ermöglichen, ist nach einem weiteren Vorschlag der Erfindung vorgesehen, dass ein von dem zweiten metallischen Kontakt der ersten Schutzdiode ausgehender Verbinder mit einem von dem zweiten metallischen Kontakt der zweiten Schutzdiode ausgehender Verbinder über der Vorderseite der ersten und zweiten Solarzelle bzw. deren Deckgläser vorsteht und außerhalb der Deckgläser vorzugsweise durch Schweißen oder Löten verbunden sind.

Losgelöst davon, ob die Solarzellen über eine Schutzdiode oder mehrere Schutzdioden verbunden sind, sieht ein eigenerfinderischer Vorschlag der Erfindung vor, dass die erste Solarzelle und/oder die zweite Solarzelle in Draufsicht eine Rechteckform mit abgeschrägten Ecken ist und dass die zumindest eine Schutzdiode im Bereich einer der abgeschrägten Ecken verläuft. Hierdurch ergibt sich eine optimale Nutzung der panel-Oberfläche, wobei gleichzeitig ein einfaches Verschalten von Schutzdioden und Solarzellen ermöglicht wird.

Insbesondere ist vorgesehen, dass mehrere zu einem string verschaltete Solarzellen über entsprechende Schutzdioden verbunden sind. Dabei kann in jeder abgeschrägten Ecke eine Schutzdiode angeordnet sein. Schutzdiode und Solarzellen liegen dabei in einer Ebene.

Erfindungsgemäß wird vorgeschlagen, dass die Schutzdiode in Draufsicht eine Dreiecksgeometrie aufweist.

Insbesondere ist vorgesehen, dass die Schutzdiode die Geometrie einer Dreieckssäule aufweist.

Dabei sollte bei einer Solarzelle quadratischer Fläche mit abgeschrägten Ecken und einer Kantenlage von 8 cm, bevor die Ecken entfernt sind, die Schutzdiode eine Grundfläche F von vorzugsweise in etwa $0{,}7 \text{ cm}^2 \leq F \leq 1 \text{cm}^2$, insbesondere von in etwa $0{,}8 \text{ cm}^2 \leq F \leq 0{,}9 \text{ cm}^2$ aufweisen.

Ferner bezieht sich die Erfindung auf ein Verfahren zum Verschalten eines Solarzellenstrings, das durch die Verfahrensschritte gekennzeichnet ist:

- Anordnen der Solarzellen mit der Rückseite auf einer Unterlage,

- Verbinden frontseitiger Kontakte der Solarzellen mit ersten Verbindern,
- Befestigen einer oder mehrerer transparenter Abdeckungen auf den Frontseiten der Solarzellen,
- Wenden der Solarzellen,
- Verbinden der ersten und zweiten Solarzellen über die ersten Verbinder zu dem string,
- Einbringen von Schutzdioden in zwischen den Solarzellen vorhandene Freiräume,
- Verbinden der Schutzdioden mit den Solarzellen und
- Verbinden so hergestellten strings mit einer Unterlage.

Dabei werden insbesondere vor dem Einbringen der Schutzdioden benachbarte Solarzellen über die ersten Verbinder in Reihe verschaltet.

In Weiterbildung ist vorgesehen, dass Schutzdioden mit ihren Rückseitenkontakten, also dritten metallischen Kontakten im frontseitigen Bereich der Solarzellen angeordnet werden und dass benachbarte Solarzellen über zumindest jeweils eine Schutzdiode in Serie verschaltet werden bei gleichzeitiger antiparalleler Verschaltung der Schutzdiode zu einer der benachbarten Solarzelle.

Insbesondere sind die Verfahrensschritte vorgesehen:

a) Anordnen der Solarzellen mit der Rückseite auf einer Unterlage,
b) Einbringen von Schutzdioden in zwischen den Solarzellen vorhandene Freiräume,
c) Verbinden frontseitiger Kontakte der Solarzellen mit den im string frontseitig verlaufenden zweiten Kontakten (Rückseitenkontakte) der Schutzdioden,
d) Befestigen einer oder mehrerer transparenter Abdeckungen auf den Frontseiten der Solarzellen,
e) Wenden der Solarzellen,
f) Verbinden der im string rückseitig verlaufenden ersten und dritten Kontakte (Frontkontakte) der Schutzdioden mit rückseitigen Kontakten benachbarter Solarzellen und
g) Verbinden so hergestellten strings mit einer Unterlage.
Dabei kann der string vor dem Verbinden mit der Unterlage gewendet werden.

Ferner sieht die Erfindung vor, dass zwischen zwei benachbarten Solarzellen zwei Schutzdioden angeordnet werden, von denen eine Schutzdiode mit ihrem Rückseitenkontakt (dritter metallischer Kontakt) und die andere Schutzdiode mit ihrem Frontseitenkontakt (erster und zweiter metallischer Kontakt) im frontseitigen Bereich der Solarzellen angeordnet werden, dass die benachbarten Solarzellen über die zwei Schutzdioden in Serie verschaltet werden und dass die Schutzdioden über im Bereich der Rückseiten der Solarzellen verlaufende Kontakte verschaltet werden. Dabei können von im Bereich der Rückseiten der Solarzellen verlaufenden Kontakten der Schutzdioden zweite Verbinder ausgehen, die außerhalb der Solarzellenstrings verbunden werden.

Eigenerfinderisch wird vorgeschlagen eine Diode mit einem aus Halbleitermaterial einer ersten Leitfähigkeit bestehenden Substrat einer in einem Oberflächenbereich des Substrats ausgebildeten Schicht oder auf den Oberflächenbereich aufgetragenen Schicht zweiter Leitfähigkeit, einem ersten metallischen Kontakt auf der Schicht der zweiten Leitfähigkeit und einem neben dem ersten metallischen Kontakt und zu diesem beabstandet und elektrisch isoliert über einen p/n-Übergang verbundenen zweiten metallischen Kontakt, der unmittelbar mit dem Substrat der Schutzdiode kontaktiert ist, zur Verwendung als Schutzdiode in einer Solarzellenanordnung.

Dabei kann der p/n-Übergang in der Schutzdiode durch einen Schottky-Kontakt ersetzt sein.

Weitere Einzelheiten, Vorteile und Merkmale der Erfindung ergeben sich nicht nur aus den Ansprüchen, den diesen zu entnehmenden Merkmalen - für sich und/oder in Kombination-, sondern auch aus der nachfolgenden Beschreibung von der Zeichnung zu entnehmenden bevorzugten Ausführungsformen.

Es zeigen:

Fig. 1    eine erste Ausführungsform einer Schutzdiode,

Fig. 2    eine weitere Schutzdiode,

Fig. 3    eine zur Fig. 1 alternative Ausführungsform einer Schutzdiode mit Stromkreislauf,

Fig. 4    eine Prinzipdarstellung zweier aus einem Halbleiter-wafer hergestellter Solarzellen mit abgeschrägten Ecken,

Fig. 5    im Querschnitt und im Ausschnitt ein Solarzellenstring,

Fig. 6    einen Querschnitt durch ein panel mit über Schutzdioden verbundene Solarzellen,

Fig. 7      Rückansicht eines Ausschnitts eines strings mit Schutzdioden unterschiedlicher Geometrien,

Fig. 8      eine weitere Ausführungsform eines panels im Ausschnitt mit über Schutzdioden verbundene Solarzellen,

Fig. 9      lichteinfallseitiger Ausschnitt eines über Schutzdioden verschalteten strings;

Fig. 10      die Darstellung gemäß Fig. 9, jedoch von der Rückseite her,

Fig. 11      eine Prinzipdarstellung einer Solarzelle mit abgeschrägten Ecken,

Fig. 12      eine Solarzelle mit abgeschrägten Ecken und in diesen angeordneten Schutzdioden,

Fig. 13      einen Querschnitt durch ein panel mit jeweils über zwei Schutzdioden verschalteten Solarzellen,

Fig. 14      eine Ausgestaltung der Solarzellenverbindungen über Schutzdioden gemäß Fig. 13,

Fig. 15      eine Prinzipdarstellung eines ersten Prozesses zur Verschaltung von Solarzellen und

Fig. 16      eine Prinzipdarstellung eines zweiten Prozesses zur Verschaltung von Solarzellen.

Nachstehend wird anhand der den Figuren zu entnehmenden Ausführungsbeispiele die Gestaltung diskreter Schutzdioden für Solarzellen und ihre Integration in ein Solarzellen-string bzw. -panel näher beschrieben. Dabei werden gleiche Elemente mit gleichen Bezugszeichen oder entsprechenden Bezugszeichen versehen.

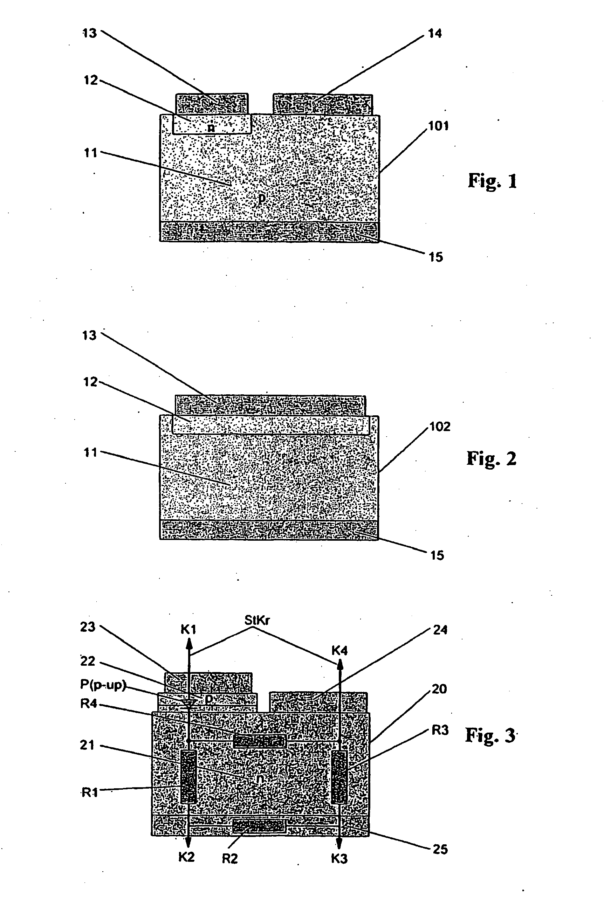

In Fig. 1 ist eine erfindungsgemäße Schutzdiode 101 einer ersten Ausführungsform dargestellt, die aus einem Halbeitermaterial wie Silizium, Germanium oder einem Material aus der III. und V. Gruppe des Periodensystems wie GaS oder GaP oder GaInAs oder GaInP besteht. Dabei kann der Hauptkörper, d. h. das Substrat 11 p-leitend dotiert sein. In einem Oberflächenbereich und zwar im Bereich der Frontseite der Schutzdiode 101 ist bis hin zur Oberfläche ein n-dotierter Bereich 12 ausgebildet, der mit dem Substrat 11 einen rückwärts gut sperrenden n-/p-Übergang (n-up-Diode), also die eigentliche Schutzdiode bildet.

Wie die Darstellung gemäß Fig. 1 verdeutlicht, erstreckt sich der n-dotierte Bereich nur über einen Teil der Oberseite des Substrats 11. Der n-dotierte Bereich ist außenseitig durch einen metallischen Kontakt 13 abgedeckt. Dieser wird als erster Kontakt bezeichnet. Entlang der Rückseite erstreckt sich ein elektrisch leitender Kontakt 15 mit der Leitfähigkeit des Substrats 11 und befindet sich mit diesem im ohmschen Kontakt. Dieser Kontakt wird als dritter Kontakt bezeichnet. Beabstandet zu dem ersten Kontakt 13 und elektrisch isoliert zu diesem ist auf der Oberseite des Substrats 11, also außerhalb des n-dotierten Bereichs 12, ein weiterer metallischer Kontakt 14 aufgebracht, der im ohmschen Kontakt mit dem Substrat 11 steht. Dieser Kontakt wird als zweiter Kontakt bezeichnet. Über die elektrisch leitenden ersten und zweiten Kontakte 13, 14 auf der Vorderseite der Schutzdiode 101 und den Rückkontakt 15 (dritter Kontakt) werden in nachstehend beschriebener Weise Solarzellen verschaltet.

Eine weitere Schutzdiode 102 ist der Fig. 2 zu entnehmen. Dabei erstreckt sich der n-dotierte Oberflächenbereich 12 weitgehend entlang der gesamten Oberseite. Der n-dotierte Bereich 12 ist sodann von dem ersten metallischen Kontakt 13 abgedeckt. Ansonsten entspricht die Schutzdiode 102 vom Aufbau her der Schutzdiode 101.

In der Praxis können zur Verbesserung der Eigenschaften der Schutzdioden 101, 102 Isolationsschichten und/ oder Passivierung und/oder Metallisierungen auf dem Halbleiter bzw. den Halbleiterschichten 11, 12 oder auch auf Teilen der metallischen Kontakte 13, 14, 15 aufgebracht sein.

Die Dimensionierung der Schutzdioden 101, 102 wird zweckmäßigerweise so gewählt, dass diese in einem string in Bereichen angeordnet sind, die von Solarzellen nicht bedeckt sind, die vorzugsweise als cropped corner cells ausgebildet sind, d. h. Solarzellen mit abgeschrägten bzw. abgeschnittenen Ecken. Dabei sollten die Schutzdioden 101, 102 in den entfernten Ecken der Solarzellen insbesondere im Bereich voneinander angrenzender Solarzellen angeordnet sein, um die Solarzellen in nachstehend beschriebener Weise zu verschalten.

Anstelle von Schutzdioden 101, 102 mit n/p-Übergang, als n-up-Dioden, können auch Schutzdioden mit vertauschter Dotierung für entsprechend dotierte Solarzellen benutzt werden. In diesem Fall werden die Dotierungen vertauscht, d. h. p → n und n → p.

In Fig. 3 ist eine weitere Ausführungsform einer erfindungsgemäßen Schutzdiode 20 dargestellt, die prinzipiell der Schutzdiode 101 entspricht. Flächenmäßig kann bei der Schutzdiode 20 zunächst der p/n-Übergang auf eine Seite der Oberfläche ganzflächig hergestellt werden. Beispielhaft ist Diffusion oder Ionen-ImplantaLion eines entsprechenden Dotierstoffs oder epitaktisches Abscheiden von Schichten und anschließendes Entfernen (Abätzen) eines Teils des dem Substrat 21 entgegengesetzt dotierten Bereichs 22 zu nennen. Die in Fig. 3. dargestellte Schutzdiode 20 ist eine solche des Typs p-up, wobei auf der p-leitenden Schicht 22 ein metallischer Kontakt 23 als der erste Kontakt aufgebracht ist.

Beabstandet und elektrisch isoliert von diesem und im ohmschen Kontakt zum n-leitenden Substrat 21 ist der zweite metallische Kontakt 24 angeordnet. Entlang der Rückseite des Substrats 21 erstreckt sich der dritte metallische Kontakt 25 oder Rückkontakt.

Dass Schutzdioden zuvor beschriebener Art, also Schutzdioden 101, 102 und 20, insbesondere die der Fig. 1 und Fig. 3 in verschiedenen Anwendungen vorteilhaft eingesetzt werden können, soll anhand der Schutzdiode 20 verdeutlicht werden können. Hierzu sind in dieser das elektrische Schaltbild (StKr) einschließlich der möglichen Anschlusspunkte K1, K2, K3, K4 und die im Inneren elektrisch wirkenden Elemente dargestellt, d. h., die Diode (P(p-up)), die Widerstände R1 und R3, die zwischen den Anschlüssen K1 und K2 bzw. K4 und K3 verlaufen, sowie der Widerstand R4, der im Ausführungsbeispiel horizontal durch das n-leitende Substrat 21 verläuft, und der Widerstand R2, der im rückseitigem Kontakt 25 (dritter Kontakt) herrscht.

Eine grobe Abschätzung des maximalen zusätzlich zum Spannungsabfall am p/n-Übergang auftretenden Spannungsverlustes $\Delta V$ in der Diode 20 aufgrund des Spannungsverlusts an den inneren Widerständen R1 bis R4 bei einem angenommenen Strom von I = 1 A errechnet sich aus $\Delta V = R \cdot I$ mit $R = [(R1 + R2 + R3) \cdot R4]/[R1+R2+R3+R4]$. Die Abschätzung wurde so ausgeführt, dass die errechneten Widerstände immer größer sind als sie in der Realität tatsächlich wären, der Spannungsverlust dementsprechend in der Realität kleiner ausfallen wird.

Als Rechenbeispiel diene eine Diode, die der Diode 101 entspricht und aus 20 mΩcm Si- Substrat (p 1 = 2E-2 Ωcm) hergestellt ist. Die Form entspricht der der Fig. 6, die Fläche der Diode 101 betrage F1 = 1cm$^2$, p- (14) und n- (13) Bereich betrage jeweils Fn = Fp = 0,5cm$^2$, wobei die doppelte Fläche der Diodenunterseite nicht berücksichtigt werde. Die Dicke der Diode 101 sei D1 = 150 μm = 0,015 cm, die Länge der Trennungskante B 1 zwischen den Kontakten 13 und 14 betrage B 1 = 1.2 cm, ihr Abstand S1 betrage S 1 = 100 μm (0.01 cm), die Dicke D2 der Metallisierung (p 2 = 1.6E-6 Ωcm) aus Ag: D2 = 10 μm (0,001 cm), der Abstand A1 zwischen den Verbindern 40a und 40b betrage A1 = 0.5 cm.

Die Abschätzung finde mit Hilfe der Formel für die Berechnung von Widerständen aus Spezifischem Widerstand ρ und äußerer Geometrie des Widerstands, d. h. Länge L und Querschnitt F statt: $R = \rho \cdot$ Länge L / Querschnitt F.

Für R1 und R3 (vertikaler Widerstand im Substrat 21) gilt die Abschätzung:

ρ1 = 2E-2 Ωcm Silizium
für beide R 1 und R2 gilt: Fläche F = Fp (14) = Fn (13) = 0.5 cm$^2$,
Länge L = D 1 = 0.015 cm
R1 = R3 = 1.5E-4 Ω

Für R2 im Kontaktmetall aus Ag ; Dicke D2 = 10μm (0.001cm), ρ = 1.6E-6 Ωcm

F berechnet sich aus F = D2 · B1 =0.0006cm · 1,2cm = 7.2E-4 cm$^2$,
Länge L = A1 = 0,5 cm
R2 = 6,6E-4 Ω

Für R4 (horizontaler Widerstand im Substrat) : ρ1 = 2E-2 Ωcm Silizium
F bestimmt sich F aus der Dicke D1 und B1 zu F = D1 · B1 = 1,2 cm,
Länge L = A1 = 0.01 cm

R4=1,1E-2Ω

Der Spannungsverlust $\Delta V = R \cdot I$:

$$\Delta V = [(R1 + R2 + R3)*R4]/[R1+R2+R3+R4]*I$$

$$\Delta V = 0.88E\text{-}3V = 0.88mV \;.$$

In der Praxis wird dieser Spannungsabfall noch geringer zu realisieren sein.

Da bei Verwendung einer Silizium Diode der Spannungsabfall am p/n- Übergang ca. 0,68 V (680 mV) beträgt, wird der Spannungsabfall an den inneren Widerständer der Schutzdiode daher nur einen sehr geringen zusätzlichen Beitrag liefern.

Anhand der nachstehenden Erläuterungen soll der Einsatz der erfindungsgemäßen Schutzdioden unter Berücksichtigung von Standard-Verbindungstechniken von Solarzellen näher erläutert werden.

Das derzeit favorisierte Design einer Solarzelle 30 mit abgeschrägten Ecken ("cropped comer") 32 aus III-V-Material hergestellt unter Zugrundelegung eines Epitaxie-wafers 31 von 100 mm Durchmesser ist schematisch der Fig. 4 zu entnehmen, und zwar von der Lichteinfallseite her dargestellt. Die metallenen Stromsammelbalken 33 mit den Kontaktflächen 34 zum Anbringen der elektrischen seriellen Verbindungen (Verbinder) zwischen den Zellen 30 im string liegen auf der kürzeren durch die beiden cropped corner 32 begrenzten Seite der beiden längeren Seiten, die unmittelbar an die im string seriell verbundenen Zellen angrenzen. Bei weitgehend optimaler Nutzung der wafer- Fläche betragen die Kantenlängen a, b, c der Zelle 30 z. B. a = 8 cm, b = 4 cm und c = 1,35 cm.

Auf string-Ebene verbleibt in diesem Fall somit bei einem Winkel von 45° zwischen den Kanten der Ränder b und c als nicht zur Konvertierung des Lichts benutzt eine dreieckige Fläche mit Kanten der Längen Ld = ca. 0,95 cm/ 0,95 cm/1,35 cm, d. h. einer Fläche von Fd = ca. 0,9 cm$^2$.

In Fig. 5 ist im Querschnitt und im Ausschnitt rein schematisch eine mögliche Verbindungsart von Zelle zu Zelle und Zelle zu Diode dargestellt, wobei Letztere dem Typ der Fig. 2 entspricht. Zur Verdeutlichung ist das Stromverlaufsdiagramm miteingezeichnet, das mit 4b7 gekennzeichnet ist.

Bei den Solarzellen 30a, 30b handelt es sich um solche des triple-Typs, wobei beispielsweise auf einem Germanium-Substrat eine Ge-Bottomzelle, auf diese eine GaInAs-Mittelzelle und schließlich eine GaInP-Topzelle aufgetragen sind, die durch Tunneldioden getrennt sind. Insoweit wird jedoch auf hinlänglich bekannte Solarzellentypen verwiesen. Die Solarzellen selbst werden über einen Kleber 4b6 auf einer Unterlage 4b5 befestigt. Lichteinfallseitig sind die Solarzellen 30a, 30b und damit auch die Schutzdioden 102 über einen Kleber 4b3a, 4b3b mittels eines Deckglases 4b2a, 4b2b abgedeckt.

Im Ausführungsbeispiel ist die oberste Halbleiterschicht der Zellen 30a, 30b n-leitend (n-up-Zellen), ohne dass hierdurch eine Einschränkung der erfindungsgemäßen Lehre erfolgt.

In einem üblichen Herstellungsverfahren von strings für panels, die die Funktion des Trägers 4b5 ausüben, werden zunächst die Verbinder 4bl auf der Lichteinfallseite (Vorderseite) der Solarzellen 30a, 30b an den frontseitigen Kontaktflächen 34 befestigt. Sodann wird das Deckglas 4b2a mittels des Klebers 4b3a aufgebracht. In diesem Zustand wird die Solarzelle auch als CIC (connector integrated cell) oder SCA (solar cell assembly) bezeichnet. Die Solarzellen werden sodann zur Verbindung zu einem string umgedreht, so dass die Rückseite oben liegt. Sodann werden die Verbinder 4b1 durch z.B. Schweißen oder Löten elektrisch mit der Rückseite der angrenzenden Zelle, im Ausführungsbeispiel der Nachbarzelle 30b, verbunden.

Zu diesem Zeitpunkt gestaltet sich die Einbringung einer erfindungsgemäßen Diode 102, also im Ausführungsbeispiel.einer n-up-Diode für eine n-up-Solarzelle 30a, in eine der abgeschnittenen Ecken (cropped corner) der Zelle 30a - oder in jede abgeschnittene Ecke eine entsprechende erfindungsgemäße Diode 102 - der gleichen Art, jedoch spiegelsymmetrisch im Design - besonders einfach. So werden an der p-leitenden Seite, also im dargestellten Fall der n-up-Diode auf dem metallischen Kontakt 15, dem p-Kontakt ein dem Verbinder 4b1 entsprechender Verbinder 40b und an den den n-leitenden Bereich 12 abdeckenden metallischen Kontakt 13 ein zweiter Verbinder 40a angebracht, die Diode 102 in eine der cropped corner eingelegt, um sodann elektrisch leitende Verbindungen einerseits zwischen der Rückseite der Zelle 30b und dem metallischen Kontakt 15 der Schutzdiode 102 und andererseits über den Verbinder 40a zwischen dem Kontakt 13 und dem Rückkontakt der Solarzelle 30a herzustellen (s. Stromdiagramm 4b7). Bei Verwendung einer p-up-Diode sind die Kontakte 13 und 15 zu tauschen. Zweckmäßigerweise kann die Diode 102 ebenfalls mit einen Kleber 4b3b mit einem Deckglas 4b2b versehen sein oder das Deckglas 4b2a der Zelle 30a wird so groß ausgelegt, dass die Diode 102 unmittelbar eingeklebt und elektrisch in zuvor beschriebener Art verbunden werden kann

Der weitere Verlauf der panel-Herstellung durch das Aufbringen des strings mittels des Klebers 4b6 auf die Unterlage 4b5 wird erkennbar durch den Einbau der Schutzdiode 102 nicht berührt.

Für eine p-up-Zelle vom prinzipiell demselben Design wie in Fig. 5 ist z. B. eine Diode 102 mit entsprechender entgegengesetzter Dotierung in derselben Weis einsetzbar.

Der Einsatz der Diode 101 (Fig. 1) gestaltet sich noch einfacher, da ein Anbringen von Verbindern an der Diode 101 vor dem Einlegen in die string-Anordnung nicht erforderlich ist, wie sich aus der Fig. 6 ergibt.

In Fig. 6 ist rein schematisch ein Querschnitt durch eine mögliche Verbindungsart von Zelle 30a zu Zelle 30b und den Zellen 30a, 30b mit der Schutzdiode 101 dargestellt. Auch hier ist zur Verdeutlichung das Stromverlaufsdiagramm 4b7 eingezeichnet. Anstelle der Diode 101 gemäß Fig. 1 kann auch eine Diode 20 gemäß Fig. 3 eingebaut werden, ohne dass die Erfindung verlassen wird. Gleiches gilt für die weiteren Ausführungsbeispiele.

Bei den Solarzellen 30a, 30b handelt es sich um solche, die im Zusammenhang mit der Fig. 5 beschrieben worden sind, so dass auf die diesbezüglichen Ausführungen verwiesen wird. Folglich handelt es sich, ohne dass hierdurch eine Beschränkung der Erfindung erfolgen soll, um Solarzellen 30a, 30b des Typs n-up. Beim Standard-Herstellungsprozess von strings für panels werden zunächst die Verbinder 4bl auf der Lichteinfallseite der Solarzellen 30a, 30b an die Frontkontakte 34 angebracht, sodann das Deckglas 4b2a mittels des Klebers 4b3 aufgebracht, die entsprechenden CICs genannten Solarzellen 30a, 30b zur Verbindung zu einem string umgedreht, so dass die Rückseite nach oben zeigt, um sodann die Verbinder 4b1 durch z. B. Schweißen oder Löten elektrisch mit der jeweiligen Nachbarzelle zu verbinden, also im Ausführungsbeispiel mit der Zelle 30b.

Gleichzeitig wird - wie zuvor erläutert - die Schutzdiode 101 eingebracht, die entsprechend der n-up-Zelle eine n-up-Diode und antiparallel geschaltet ist. Das Anbringen der Schutzdiode 101 erfolgt dabei in einer der cropped corner der Zelle 30a. Gegebenenfalls kann auch in jede cropped corner eine entsprechende Schutzdiode 101 eingebracht werden, wobei das Design spiegelsymmetrisch ist. Das Anbringen ist dabei im Vergleich zu der Gestaltung der Fig. 5 noch einfacher, da nach dem Einlegen der Diode 101 in die Anordnung der nebeneinander liegenden Zellen 30a, 30b einzig und allein die Verbinder 40a und 40b zwischen der sich entlang der n-dotierten Schicht 12 erstreckenden metallischen Schicht bzw. dem ersten metallischen Kontakt 13 mit der Rückseite der Solarzelle 30a und der unmittelbar auf dem p-leitenden Substrat 11 verlaufende elektrisch leitende zweite Kontakt 14 mit der Rückseite der Solarzelle 30b in einer Art verbunden werden muss, wie dies auch zwischen den Zellen erfolgt. Zweckmäßigerweise kann auch hier die Diode 101 durch einen Kleber 4b3b mit einem Deckglas 4b2b versehen sein oder das Deckglas der Zelle 4b2a wird groß genug ausgelegt, um die Diode 101 unmittelbar einzukleben und elektrisch auf diese Art zu verbinden.

Der weitere Verfahrensablauf der panel-Herstellung wie das Aufbringen des strings mittels eines weiteren Klebers 4b6 auf die Unterlage 4b5 wird durch den Einbau der Diode 101 nicht berührt.

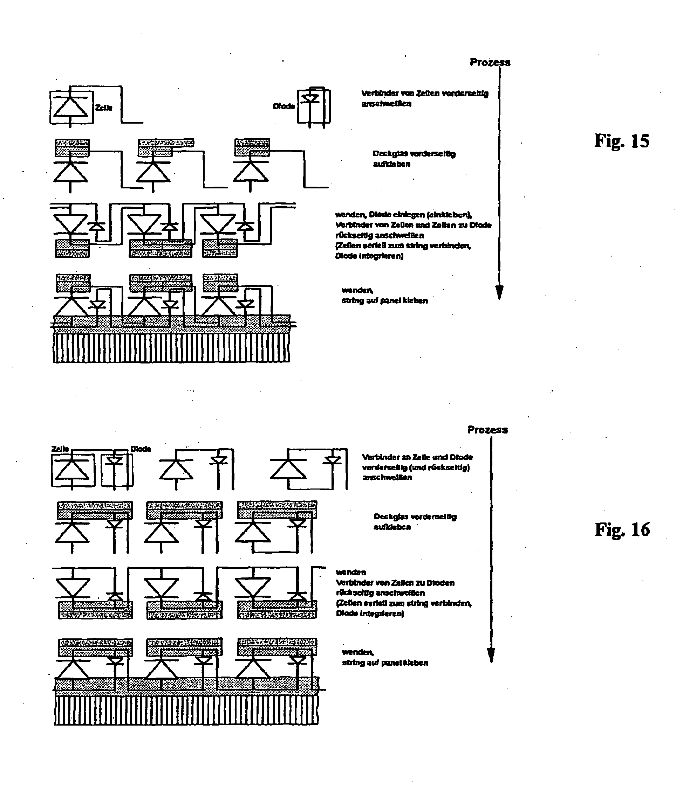

Der zuvor erläuterte Prozess mit den wesentlichen Verfahrensschritten ist noch einmal rein prinzipiell in der Fig. 15 dargestellt.

Für eine p-up-Zelle mit vom Prinzip her demselben Design wie dem der Fig. 6 ist eine Diode entsprechend der der Fig. 1 mit der Einschränkung einsetzbar, dass das Substrat n-leitend und die dotierte Oberflächenschicht p-leitend ist.

Ferner besteht die Möglichkeit, die Schutzdiode 101 zwischen der ersten Solarzelle 30a und der zweiten Solarzelle 30b derart zu verschalten, dass der erste Kontakt 13 mit dem Rückseitenkontakt der zweiten Solarzelle 30b und der zweite Kontakt 14 mit der Rückseite der ersten Solarzelle 30a verbunden wird. Bei entsprechender Verschaltung muss der p/n-Übergang entsprechend umdotiert sein.

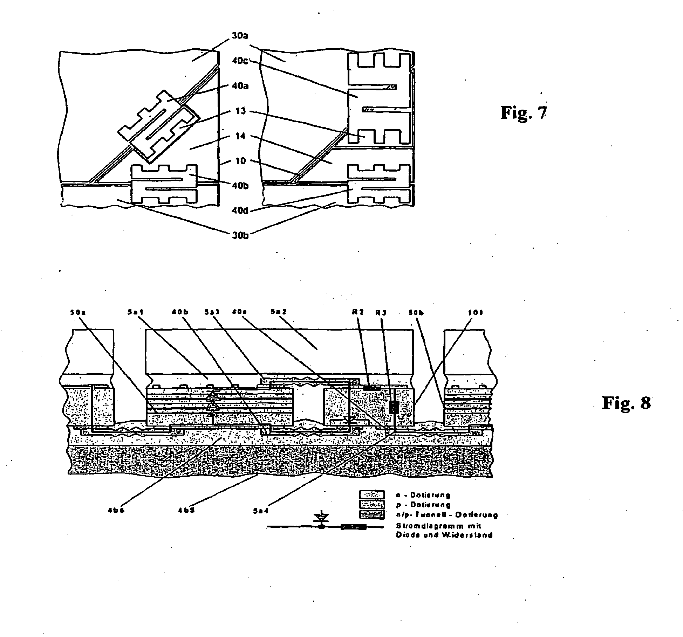

In Fig. 7 sind im Ausschnitt zwei Teilansichten eines strings von Zellen 30a, 30b mit Schutzdioden 101 von der Rückseite aus betrachtet dargestellt, die zu einem string verschaltet werden. Dabei unterscheiden sich die Zellenstrings dahingehend, dass das Design der Verbindungen zwischen der Schutzdiode 101 und den Solarzellen 30a bzw. Solarzellen 30b voneinander abweicht.

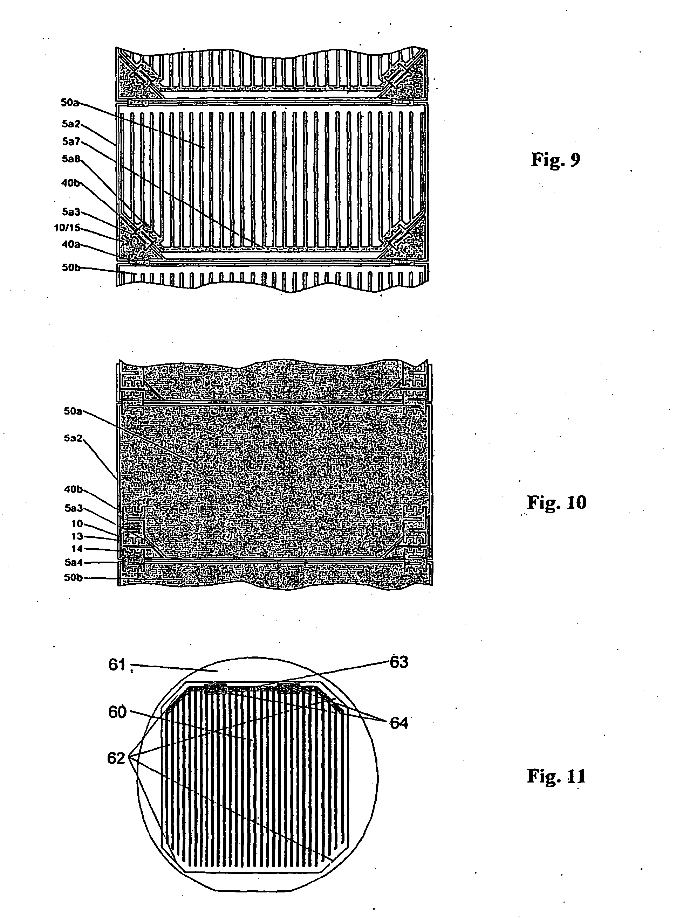

Der Fig. 8 ist eine bevorzugte Weiterbildung und Nutzung der erfindungsgemäßen Schutzdiode zu entnehmen, die nicht nur antiparallel zu einer Solarzelle geschaltet wird, sondern gleichzeitig als Teil der Verbindung zwischen aneinander grenzenden Zellen dient. Die vereinfachte panel-Fertigung ergibt sich aus den Fig. 8 bis 10 und 16, wobei ebenfalls - ohne Einschränkung der Allgemeinheit - die zu verbindenden Solarzellen 50a, 50b des Typs n-up-Zelle sind. Dabei werden vorteilhafterweise zwei Schutzdioden 101 bzw. 20 - in zweckmäßiger Weise spiegelsymmetrischem Design - zum Verbinden aufeinander folgender Solarzellen 50a, 50b benutzt, wie sich dies unmittelbar aus den Fig. 9 und 10 ablesen lässt. Dabei wird jeweils eine Schutzdiode 101 in einer abgeschrägten Ecke der Solarzelle 50a vor dem Aufbringen des gemeinsamen Deckglases 5a2 mittels eines Klebers 5a1 durch einen Verbinder 5a3 elektrisch dergestalt verbunden, dass die Vorderseite der Zelle 50a mit der Unterseite der Diode 101 verbunden ist, d. h. der dritte Kontakt 15 bzw. 25 gemäß Fig. 1, 3 entlang Frontseite der zu einem string verschalteten Solarzellen 50a, 50b verläuft. Hierzu sind im Design der Zelle 50a Kontaktflächen 5a am Randbereich der abgeschrägten Ecken (cropped corner) ausgebildet, die mit den Stromsammelbacken 5a7 verbunden sind. Die Solarzelle 50a mit Schutzdioden 101 bzw. 20 ist sodann durch Anbringung eines Verbinders 40a zwischen dem unmittelbar mit dem Substrat 11 der Schutzdiode 101 bzw. 20 kontaktierten zweiten metallischen Kontakt 14 bzw. 24 und der Rückseite der Zelle 50b und durch Anbringen eines Verbinders 40b zwischen dem auf der p-dotierten Schicht 12 angeordneten ersten elektrisch leitendem Kontakt 13 bzw. 23 und der Rückseite der Solarzelle 50a verbunden und in dem string integriert. Die weitere Aufbringung auf das panel entspricht zuvor erfolgter Erläuterungen.

In Fig. 8 ist das Stromdiagramm 5a4 mit den relevanten Dioden und Widerständen eingezeichnet.

Der Verbinder 40b kann - wie dem Verfahrensablauf in Fig. 16 zu entnehmen ist - auch vor dem Aufbringen des gemeinsamen Deckglases 5a2 zwischen der Rückseite der Zelle 50a und dem Kontakt 13 der Diode 10 angebracht werden.

Der Fig. 16 ist rein prinzipiell der Verfahrensablauf zu entnehmen, um die Schutzdiode 101 - und entsprechend die Schutzdiode 20 - mit den Solarzellen 50a, 50b bzw. antiparallel zu der Solarzelle 50a zu verschalten. So werden zunächst in den "freien" Ecken der Solarzellen 50a, 50b die Schutzdioden 101 angeordnet und die Frontkontakte der ersten Solarzellen 50a und der zweiten Solarzellen 50b jeweils mit den üblicherweise als Rückkontakt zu bezeichnenden dritten Kontakten von Schutzdioden 101 verbunden. Dabei ist jeder ersten und zweiten Solarzelle 50a, 50b eine gesonderte Schutzdiode 101 zugeordnet. Hierzu wird ein erster Verbinder 5a3 benutzt. Zu diesem Zeitpunkt kann auch schon der Verbinder 40b angebracht werden, Sodann wird auf jeweils eine Solarzelle mit mit dieser verschalteter Schutzdiode ein Deckglas 5a2 geklebt, so hergestellte Einheiten umgedreht und sodann - falls teilweise nicht schon zuvor geschehen - die ersten und zweiten Kontakte 13, 14 von Schutzdioden 101 mit ersten und zweiten Solarzellen verbunden wie verschweißt, um die Solarzellen seriell zu einem string bei gleichzeitiger Integration der Schutzdioden zu verbinden. Nach dem Wenden des so hergestellten strings wird dieser in gewohnter Weise auf ein panel geklebt.

Eine Abschätzung des durch die Anwendung der Schutzdiode in der beispielhaften Art entstehenden zusätzlichen Spannungsabfalls zwischen den Zellen 50a und 50b kann für dieses Beispiel wieder aus der Fig. 3 entnommen werden. Hierbei fließt der Strom vom Anschlusspunkt K2 nach K4. Der Strom wird durch serielle Widerstände R2 + R3 fließen (die Widerstände R3+R4 liegen parallel und vermindern höchstens den Gesamtwiderstand), der Spannungsabfall bei I=1A Stromfluss wird daher höchstens

$$\Delta V = (R2 + R3) \cdot I = (6{,}6\text{E-}4 + 1.5\text{E-}4) \cdot 1A = 8{,}1\text{E-}4 \text{ V} = 0.81 \text{ mV}$$

und wird in der Praxis geringer sein.

Die Tendenz zu größeren Solarzellen macht die Einführung von Solarzellen mit den Hauptachsen von ca. 8 cm • 8 cm immer wahrscheinlicher. Dabei wird pro 4"(4-Zoll)-wafer eine Zelle hergestellt, so dass die Reduzierung des fertigen Aufwandes von besonderer Bedeutung und damit die Anwendung leicht zu integrierender diskreter Schutzdioden wichtig ist.

Fig. 11 zeigt ein mögliches Design einer solchen Solarzelle 60 mit insgesamt 4 cropped corner 62. Entsprechende Solarzellen 60 können gemäß zuvor erfolgter Erläuterungen mit ein oder zwei Schutzdioden von entsprechendem Design mit Nachbarzellen verschaltet werden.

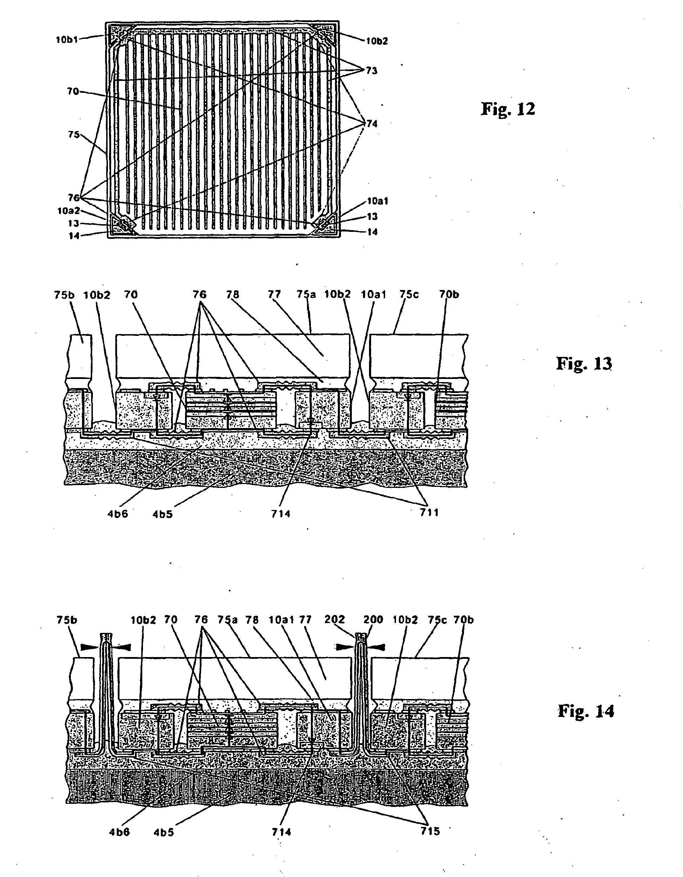

Durch ein spezielles Design einer Solarzelle 70 gemäß Fig. 12, bei der Stromsammelbacken 73 elektrisch leitend mit allen vier im Bereich der Ränder bzw. Kanten der cropped corner 76 verlegten Kontaktflächen 7 verbunden ist, können vier Dioden 10a1, 10a2, 10b1, 10b2 die Zelle 70 schützen und die Verbindung zur vorausgehenden Zelle 70a - nachfolgend Zelle 70b - entsprechend der Erläuterungen im Zusammenhang mit der Fig. 8 allein entlang der Rückseite erfolgen. Dabei erfolgt eine innere Verbindung der Zellen mit den erfindungsgemäßen Schutzdioden und äußere Verbindungen untereinander mit den erfindungsgemäßen Schutzdioden. So zeigt Fig. 13 rein prinzipiell einen Querschnitt durch ein panel mit Zellen 70, die jeweils vier cropped corner auf weisen. Die Verbindung der Zellen untereinander erfolgt über sogen, äußere Verbinder 711 auf der Rückseite der SCA 75 (SCA = solar cell assembly = Solarzelle 70 und verbundene Diode 10a1, 10a2, 10b2, 10b2 vorderseitig (lichteinfallseitig) durch den Kleber 78 mit einem gemeinsamen Deckglas 77 versehen) mittels der Schutzdioden 10a1, 10a2, 10b1, 10b2, die durch sogen, innere Verbinder 76 (innerhalb des SCAs) mit der Zelle verbunden sind.

Als Dioden 10b1 und 10b2 können sowohl die Dioden entsprechend der Fig. 2 als auch die den Fig. 1 und 3 entsprechenden Schutzdioden umgekehrter Leitfähigkeit verwendet werden, da der zweite Kontakt 14 der Diode entsprechend Fig. 1 nicht für die Anbringung eines Verbinders benötigt wird und die Fläche des ersten Kontakts 13 zur Minderung des elektrischen Widerstands in der Diode die ganze Fläche der Vorderseite einnehmen kann.

Eine Variante der äußeren Verbindung ist der Fig. 14 schematisch zu entnehmen. Da keine Gefahr des Kurzschlusses an den. Seiten der Dioden 10a1 und benachbart zu dieser verlaufenden des Typs der Fig. 1 und 2 mit umgekehrter Leitfähigkeit besteht, kann je eine Hälfte des äußeren Verbinders über die Seite des Deckglases 77 auf die Vorderseite des CIC geführt werden, um eine elektrische Verbindung durch z. B. Schweißen oder Löten (s. Pfeil) durchzuführen. Der Vorteil einer diesbezüglichen Technologie liegt darin, dass bis kurz vor der endgültigen Fertigstellung des panels das SCA vermessen werden kann und im Falle von Störungen eine Reparatur, z. B. der Austausch eines SCA relativ einfach durchführbar wäre. Ein diesbezüglicher Verbinder bietet auch die Möglichkeit, Vorderseite des Deckglases 77 gegen elektrostatische Aufladung mit der Zelle zu verbinden.

Insbesondere aus den Fig. 7, 9, 10 und 12 ergibt sich, dass die Schutzdioden 20, 101 in Draufsicht eine Dreiecksgeometrie, vorzugsweise eine solche mit rechtem Winkel und insbesondere gleich langen Schenkeln aufweisen. Andere Geometrien sind gleichfalls möglich. Unabhängig hiervon füllen die Schutzdioden die zwischen den Solarzellen durch die cropped corner bedingten Freiräume aus.

**Patentansprüche**

1.  Solarzellenanordnung umfassend zumindest eine erste Solarzelle (30a, 50a, 60, 70) mit zwischen Front- und Rückkontakt (34) verlaufenden photoaktiven Halbleiterschichten sowie zumindest eine mit der Solarzelle verbundene diskrete Schutzdiode (101, 20, 10a1, 10b2, 10b3) mit einem aus Halbleitermaterial einer ersten Leitfähigkeit bestehenden Substrat (11, 21), in einem Oberflächenbereich des Substrats ausgebildeter Schicht (12) oder auf den Oberflächenbereich aufgetragener Schicht (22) zweiter Leitfähigkeit, einen ersten metallischen Kontakt (13, 23) auf der Schicht der zweiten Leitfähigkeit und einen auf dem Substrat angeordneten zweiten metallischen Kontakt (14, 24), wobei von dem ersten und dem zweiten metallischen Kontakt Verbinder (5a3, 4b7, 40a, 40b, 40c) zum Verschalten der Schutzdiode ausgehen,
    **dadurch gekennzeichnet,**

**dass** der zweite Kontakt (14, 24) unmittelbar mit dem Substrat (11, 21) der Schutzdiode (121, 10a1, 10b2, 10b3) kontaktiert und neben dem ersten metallischen Kontakt (13, 23) und zu diesem beabstandet angeordnet und mit dem ersten metallischen Kontakt elektrisch über einen p/n-Übergang verbunden ist.

**2.** Solarzellenanordnung nach Anspruch 1,
**dadurch gekennzeichnet,**
**dass** auf in Bezug auf den ersten und den zweiten Kontakt (13, 23; 14, 24) gegenüberliegender Seite des Substrats (11, 21) auf diesem ein dritter metallischer Kontakt (15, 25) angeordnet ist.

**3.** Solarzellenanordnung nach Anspruch 2,
**dadurch gekennzeichnet,**
**dass** der dritte metallische Kontakt (15, 25) mit der ersten Solarzelle (30a, 50a, 60, 70) oder mit einer zweiten Solarzelle (30b, 50b, 70b) verbunden ist.

**4.** Solarzellenanordnung nach Anspruch 1,
**dadurch gekennzeichnet,**
**dass** die von dem ersten und zweiten metallischen Kontakt (13, 23, 24; 14, 24) ausgehenden Verbinder die erste Solarzelle (30a, 50a, 60, 70) mit einer zweiten Solarzelle (30b, 50b, 70b) verbinden .

**5.** Solarzelle nach Anspruch 3 oder 4,
**dadurch gekennzeichnet,**
**dass** der zweite metallische Kontakt (14, 24) mit Rückseite der zweiten Solarzelle (30b, 50b, 70b) und der dritte metallische Kontakt (15, 25) mit Frontseite der ersten Solarzelle (30a, 50a, 70) verbunden ist und umgekehrt.

**6.** Solarzellenanordnung nach zumindest Anspruch 4,
**dadurch gekennzeichnet,**
**dass** die Schutzdiode (101) über den zweiten metallischen Kontakt (14) antiparallel zu der ersten Solarzelle (30a) über die zweite Solarzelle (30b) verschaltet ist.

**7.** Solarzellenanordnung nach zumindest Anspruch 4,
**dadurch gekennzeichnet,**
**dass** die Schutzdiode (101) über den ersten metallischen Kontakt (13) antiparallel zu der ersten Solarzelle (30a) über die zweite Solarzelle (30b) verschaltet ist.

**8.** Solarzellenanordnung nach zumindest Anspruch 2,
**dadurch gekennzeichnet,**
**dass** die erste und die zweite Solarzelle (70, 70b) über zumindest zwei Schutzdioden (10a1, 10b2) verbunden sind und dass der dritte metallische Kontakt (711) der einen ersten Schutzdiode (10b2) sowohl mit dem Rückkontakt der zweiten Solarzelle (70b) als auch mit dem zweiten metallischen Kontakt der zweiten Schutzdiode (10a1) verbunden ist, deren dritter metallischer Kontakt mit dem Frontkontakt der ersten Solarzelle (70) verbunden ist (Fig. 13, 14).

**9.** Solarzellenanordnung nach Anspruch 8,
**dadurch gekennzeichnet,**
**dass** ein von dem dritten metallischen Kontakt der ersten Schutzdiode (10b2) ausgehender Verbinder (200) mit einem von dem zweiten metallischen Kontakt der zweiten Schutzdiode (10a1) ausgehenden Verbinder (202) über der Vorderseite der ersten und zweiten Solarzelle (70, 70b) bzw. deren Deckgläser (75a, 75c) vorsteht und außerhalb der Deckgläser vorzugsweise durch Schweißen oder Löten verbunden sind (Fig. 14).

**10.** Solarzellenanordnung nach Anspruch 1 oder 4,
**dadurch gekennzeichnet,**
**dass** die erste Solarzelle (30a, 50a, 70) und/oder die zweite Solarzelle (30b, 50b, 70b) in Draufsicht eine Rechteckform mit abgeschrägten Ecken ist und dass die zumindest eine Schutzdiode (101, 20, 10a1, 1 0b2, 10b3) im Bereich einer der abgeschrägten Ecken verläuft.

**11.** Solarzellenanordnung nach Anspruch 10,
**dadurch gekennzeichnet,**
**dass** mehrere zu einem string verschaltete Solarzellen über im Bereich von abgeschrägten Ecken angeordneten Schutzdioden (101, 20, 10al, 10b2, 10b3) verschaltet sind.

12. Solarzellenanordnung nach Anspruch 10 oder 11,
   **dadurch gekennzeichnet,**
   **dass** die Schutzdiode (101, 20, 10a1, 10b2, 10b3) in Draufsicht eine Dreiecksgeometrie aufweist.

13. Solarzellenanordnung nach Anspruch 10 oder 11,
   **dadurch gekennzeichnet,**
   **dass** die Schutzdiode (101, 20, 10a1, 10b2, 10b3) die Geometrie einer Dreieckssäule aufweist.

14. Solarzellenanordnung nach Anspruch 1 oder 12,
   **dadurch gekennzeichnet,**
   **dass** die Schutzdiode (101, 20, 10a1, 10b2, 10b3) eine Grundfläche F von vorzugsweise in etwa $0{,}7 \text{ cm}^2 \leq F \leq 1 \text{ cm}^2$, insbesondere von in etwa $0{,}8 \text{ cm}^2 \leq F \leq 0{,}9 \text{ cm}^2$ aufweist.

15. Solarzellenanordnung nach Anspruch 10,
   **dadurch gekennzeichnet,**
   **dass** vorzugsweise in jeder abgeschrägten Ecke der ersten und/oder zweiten Solarzelle (30a, 50a, 70; 30b, 50b, 70b) eine Schutzdiode (101, 20, 10a1, 10b2, 10b3) angeordnet ist.

16. Solarzellenanordnung nach Anspruch 1,
   **dadurch gekennzeichnet,**
   **dass** die erste Leitfähigkeit n-leitend und die zweite Leitfähigkeit p-leitend oder umgekehrt ist.

17. Solarzellenanordnung nach Anspruch 1,
   **dadurch gekennzeichnet,**
   **dass** die erste Solarzelle (30a, 50a, 70) und/oder die zweite Solarzelle (30b, 50b, 70b) eine triple-Zelle mit vorzugsweise einer Ge-Bodenzelle, vorzugsweise einer GaInAs=Mittelzelle und vorzugsweise einer GaInP-Topzelle ist.

18. Solarzellenanordnung nach Anspruch 1 oder 2,
   **dadurch gekennzeichnet,**
   **dass** zwei nebeneinander angeordnete Solarzellen (70, 70b) über zwei Schutzdioden (10a1, 10b2) verbunden sind,
   **dass** die Solarzellen solarzellenfroniseitig n-leitend sind,
   **dass** eine der Schutzdioden (10b2) frontseitig in der Schicht zweiter Leitfähigkeit p-leitend ist und
   **dass** die andere Schutzdiode (10a1) rückseitig in der Schicht zweiter Leitfähigkeit n-leitend ist und einen dritten metallischen. Kontakt aufweist (Fig. 13).

19. Solarzellenanordnung nach Anspruch 8,
   **dadurch gekennzeichnet,**
   **dass** rückseitiger Kontakt der ersten Schutzdiode (10b2) sowohl mit Rückseite der zweiten Solarzelle (70b) als auch mit dem zweiten metallischen Kontakt der zweiten Schutzdiode (10a1) verbunden ist,
   **dass** im string frontseitig verlaufender dritter metallischer Kontakt der zweiten Schutzdiode mit Frontkontakt der ersten Solarzelle (70) verbunden ist und
   **dass** der im string rückseitig verlaufende erste metallische Kontakt der zweiten Schutzdiode mit Rückseite der ersten Solarzelle verbunden ist (Fig. 14).

20. Solarzellenanordnung nach Anspruch 8,
   **dadurch gekennzeichnet,**
   **dass** bei Solarzellen mit p/n-Übergang die erste Schutzdiode einen n/p-Übergang und die zweite Schutzdiode einen p/n-Übergang aufweist.

21. Verfahren zum Verschalten eines Solarzellenstrings unter Verwendung von Schutzdioden gemäß zumindest einem der vorhergehenden Ansprüche,
   **gekennzeichnet durch** die Verfahrensschritte:

   - Anordnen der Solarzellen mit der Rückseite auf einer Unterlage,
   - Verbinden frontseitiger Kontakte der Solarzellen mit ersten Verbindern,
   - Befestigen einer oder mehrerer transparenter Abdeckungen auf den Frontseiten der Solarzellen,

- Wenden der Solarzellen,
- Verbinden der ersten und zweiten Solarzellen über die ersten Verbinder zu dem string,
- Einbringen von Schutzdioden in zwischen den Solarzellen vorhandene Freiräume,
- Verbinden der Schutzdioden mit den Solarzellen und
- Verbinden so hergestellten strings mit einer Unterlage (Fig. 6).

22. Verfahren zum Verschalten eines Solarzellenstrings unter Verwendung von Schutzdioden gemäß zumindest einem der vorhergehenden Ansprüche,
**gekennzeichnet durch** die Verfahrensschritte:

- Anordnen der Solarzellen mit der Rückseite auf einer Unterlage,
- Einbringen von Schutzdioden in zwischen den Solarzellen vorhandene Freiräume,
- Verbinden frontseitiger Kontakte der Solarzellen mit den im string frontseitig verlaufenden dritten Kontakten (Rückseitenkontakte) der Schutzdioden,
- Verbinden frontseitiger Kontakte der Solarzellen mit ersten Verbindern,
- Befestigen einer oder mehrerer transparenter Abdeckungen auf den Frontseiten der Solarzellen sowie den Schutzdioden,
- Verbinden der im string rückseitig verlaufenden ersten und zweiten Kontakte (Frontkontakte) der Schutzdioden mit rückseitigen Kontakten benachbarter Solarzellen,
- Wenden der Solarzellen und
- Verbinden so hergestellter strings mit einer Unterlage (Fig. 8).

23. Verfahren nach Anspruch 19,
**dadurch gekennzeichnet,**
**dass** Schutzdioden mit ihren dritten Kontakten im frontseitigen Bereich der Solarzellen angeordnet werden und dass benachbarte Solarzellen über zumindest jeweils eine Schutzdiode in Serie verschaltet werden bei gleichzeitiger antiparalleler Verschaltung der Schutzdiode zu einer den benachbarten Solarzelle (Fig. 6).

24. Verfahren nach Anspruch 21,
**dadurch gekennzeichnet,**
**dass** zwischen zwei benachbarten Solarzellen zwei Schutzdioden angeordnet werden, von denen eine Schutzdiode mit ihrem dritten Kontakt und die andere Schutzdiode mit ihrem ersten und zweiten Kontakt im frontseitigen Bereich der Solarzellen angeordnet werden, dass die benachbarten Solarzellen über die zwei Schutzdioden in Serie verschaltet werden und dass die Schutzdioden über im Bereich der Rückseiten der Solarzellen verlaufende Kontakte verschaltet werden (Fig. 13).

25. Verfahren nach Anspruch 21,
**dadurch gekennzeichnet,**
**dass** von im Bereich der Rückseiten der Solarzellen (70, 70b) verlaufenden Kontakten der Schutzdioden (10a1, 10b2) zweite Verbinder (200, 202) ausgehen, die außerhalb der Solarzellenstrings und in dessen frontseitigem Bereich verbunden werden (Fig. 14).

26. Solarzellenanordnung nach Anspruch 1 weiter umfassend eine Diode (101, 20, 10a1, 10b2, 10b3) mit einem aus Halbleitermaterial einer ersten Leitfähigkeit bestehenden Substrat (11, 21), einer in einem Oberflächenbereich des Substrats ausgebildeten Schicht (12, 22) oder auf den Oberflächenbereich auf getragenen Schicht zweiter Leitfähigkeit, einem ersten metallischen Kontakt (13, 23) auf der Schicht der zweiten Leitfähigkeit und einem neben dem ersten metallischen Kontakt und zu diesem beabstandet und elektrisch isoliert über einen p/n-Übergang verbundenen zweiten metallischen Kontakt (14, 24), der unmittelbar mit dem Substrat der Schutzdiode kontaktiert ist.

27. Solarzellenanordnung nach Anspruch 26,
**dadurch gekennzeichnet,**
**dass** ein dritter metallischer Kontakt (15, 25) auf in Bezug auf den ersten und zweiten metallischen Kontakt (13, 23; 14, 24) gegenüberliegender Seite des Substrats (11, 21) angeordnet ist.

28. Solarzellenanordnung nach Anspruch 26,
**dadurch gekennzeichnet,**
**dass** der p/n-Übergang in der Schutzdiode durch einen Schottky-Kontakt ersetzt ist.

**Claims**

1.  A solar cell assembly, comprising at least one first solar cell (30a, 50a, 60, 70) with photoactive semiconducting layers running between the front and rear contacts (34), as well as at least one discrete protective diode (101, 20, 10a1, 10b2, 10b3) that is connected to the solar cell and has a substrate (11, 12) consisting of a semiconducting material having a first conductivity, a layer (12) formed in a surface area of the substrate or a layer (22) having a second conductivity, which is applied on the surface area, a first metallic contact (13, 23) arranged on the layer having the second conductivity, and a second metallic contact (14, 24) arranged on the substrate, whereby connectors (5a3, 4b7, 40a, 40b, 40c) originate from the first and the second metallic contact for the purpose of interconnecting the protective diode,
    **characterized in**
    **that** the second contact (14, 24) is in direct contact with the substrate (11, 21) of the protective diode (121, 10a1, 10b2, 10b3) and is arranged beside the first metallic contact (13, 23) and at a distance therefrom, and is electrically connected to the first metallic contact by way of a p-n junction.

2.  The solar cell assembly according to claim 1,
    **characterized in**
    **that** a third metallic contact (15, 25) is arranged on the side of the substrate (11, 21) that is opposite relative to the first and second contact (13, 23; 14, 24).

3.  The solar cell assembly according to claim 2,
    **characterized in**
    **that** the third metallic contact (15, 25) is connected to the first solar cell (30a, 50a, 60, 70) or to a second solar cell (30b, 50b, 70b).

4.  The solar cell assembly according to claim 1,
    **characterized in**
    **that** the connectors that originate from the first and second metallic contact (13, 23, 24; 14, 24) connect the first solar cell (30a, 50a, 60, 70) to a second solar cell (30b, 50b, 70b).

5.  The solar cell according to claim 3 or 4,
    **characterized in**
    **that** the second metallic contact (14, 24) is connected to the rear side of the second solar cell (30b, 50b, 70b) and the third metallic contact (15, 25) is connected to the front side of the first solar cell (30a, 50a, 70), and vice versa.

6.  The solar cell assembly according to at least claim 4,
    **characterized in**
    **that** the protective diode (101) is antiparallel interconnected by way of the second metallic contact (14) to the first solar cell (30a) by way of the second solar cell (30b).

7.  The solar cell assembly according to at least claim 4,
    **characterized in**
    **that** the protective diode (101) is antiparallel interconnected by way of the first metallic contact (13) with the first solar cell (30a) by way of the second solar cell (30b).

8.  The solar cell assembly according to at least claim 2,
    **characterized in**
    **that** the first and second solar cell (70, 70b) are connected by way of at least two protective diodes (10a1, 10b2), and the third metallic contact (711) of a first protective diode (10b2) is connected to the rear contact of the second solar cell (70b) as well as to the second metallic contact of the second protective diode (10a1), whose third metallic contact is connected to the front contact of the first solar cell (70) (Figs. 13, 14),

9.  The solar cell assembly according to claim 8,
    **characterized in**
    **that** a connector (200) originating from the third metallic contact of the first protective diode (10b2) with a connector (202) originating from the second metallic contact of the second protective diode (10a1) projects over the front side of the first and second solar cell (70, 70b) or their cover glasses (75a, 75c) and are connected outside of the cover glasses preferably by welding or soldering (Fig. 14).

**10.** The solar cell assembly according to claim 1 or 4,
**characterized in**
**that** the first solar cell (30a, 50a, 70) and/or the second solar cell (30b, 50b, 70b) have a rectangular shape with cropped corners in plan view and that the at least one protective diode (101, 20, 10a1, 10b2, 10b3) runs in the area of one of the cropped corners.

**11.** The solar cell assembly according to claim 10,
**characterized in**
**that** several solar cells interconnected in a string are interconnected by way of protective diodes (101, 20, 10al, 10b2, 10b3), which are arranged in the area of cropped corners.

**12.** The solar cell assembly according to claim 10 or 11,
**characterized in**
**that** the protective diode (101, 20, 10a1, 10b2, 10b3) has a triangular geometry in plan view.

**13.** The solar cell assembly according to claim 10 or 11,
**characterized in**
**that** the protective diode (101, 20, 10a1, 10b2, 10b3) has the geometry of a triangular column.

**14.** The solar cell assembly according to claim 1 or 12,
**characterized in**
**that** the protective diode (101, 20, 10a1, 10b2, 10b3) has a base surface F of preferably about $0.7 \text{ cm}^2 \leq F \leq 1 \text{ cm}^2$, especially about $0.8 \text{ cm}^2 \leq F \leq 0.9 \text{ cm}^2$.

**15.** The solar cell assembly according to claim 10,
**characterized in**
**that** a protective diode (101, 20, 10a1, 10b2, 10b3) is preferably arranged in each cropped corner of the first and/or second solar cell (30a, 50a, 70; 30b, 50b, 70b).

**16.** The solar cell assembly according to claim 1,
**characterized in**
**that** the first conductivity is n-conducting and the second conductivity is p-conducting, or vice versa.

**17.** The solar cell assembly according to claim 1,
**characterized in**
**that** the first solar cell (30a, 50a, 70) and/or the second solar cell (30b, 50b, 70b) is a triple cell with preferably one Ge bottom cell, preferably one GaInAs center cell, and preferably one GaInP top cell.

**18.** The solar cell assembly according to claim 1 or 2,
**characterized in**
**that** two solar cells (70, 70b), which are arranged side by side, are connected by way of two protective diodes (10a1, 10b2),
**that** the solar cells are n-conducting in the solar cell front side,
**that** one of the protective diodes (10b2) in the front side within the layer having the second conductivity is p-conducting, and
**that** the other protective diode (10a1) on the rear side within the layer having the second conductivity is n-conducting and has a third metallic contact (Fig. 13).

**19.** The solar cell assembly according to claim 8,
**characterized in**
**that** rear contact of the first protective diode (10b2) is connected to rear side of the second solar cell (70b) as well as to the second metallic contact of the second protective diode (10a1),
**that** the third metallic contact of the second protective diode, which runs on the front side in the string, is connected to a front contact of the first solar cell (70), and that the first metallic contact of the second protective diode, which runs on the rear side of the string, is connected to the rear side of the first solar cell (Fig. 14).

**20.** The solar cell assembly according to claim 8,
**characterized in**

**that** in solar cells with a p-n junction, the first protective diode has an n-p junction, and the second protective diode has a p-n junction.

21. A process for interconnecting a solar cell string utilizing protective diodes according to at least one of the preceding claims,
**characterized by** the process steps;

- Arranging the solar cells with the rear side on a substrate,
- Connecting the front side contacts of the solar cells to first connectors,
- Mounting one or more transparent covers on the front sides of the solar cells,
- Turning the solar cells,
- Connecting the first and second solar cells to the string by way of the first connectors,
- Introducing protective diodes into free spaces existing between the solar cells,
- Connecting the protective diodes to the solar cells, and
- Connecting the string obtained in this way to a substrate (Fig. 6).

22. A process for interconnecting a solar cell string utilizing protective diodes according to at least one of the preceding claims,
**characterized by** the process steps:

- Arranging the solar cells with the rear side on a substrate,
- Introducing protective diodes into spaces existing between the solar cells,
- Connecting front side contacts of the solar cells to the third contacts (rear side contacts), that run on the front side in the string, of the protective diodes,
- Connecting front side contacts of the solar cells to first connectors,
- Mounting one or more transparent covers on the front sides of the solar cells as well as the protective diodes,
- Connecting the first and second contacts (front contacts) of the protective diodes running on the rear side within the string to rear side contacts of adjacent solar cells,
- Turning the solar cells, and
- Connecting the strings produced in this way to a substrate (Fig. 8).

23. The process according to claim 19,
**characterized in**
**that** protective diodes with their third contacts are arranged in the front area of the solar cells and that the adjacent solar cells are interconnected in series by way of at least always one protective diode with a simultaneous antiparallel interconnection of the protective diode with one of the adjacent solar cells (Fig. 6).

24. The process according to claim 21,
**characterized in**
**that** two protective diodes, of which one protective diode with its third contact and the other protective diode with its first and second contact are arranged in the front area of the solar cells, are arranged between two adjacent solar cells, that the adjacent solar cells are interconnected in series by way of the two protective diodes, and that the protective diodes are interconnected by way of contacts that run within the area of the rear side of the solar cells (Fig. 13).

25. The process according to claim 21,
**characterized in**
**that** second connectors (200, 202), which are connected outside of the solar cell strings and within its front side area, originate from contacts of the protective diodes (10a1, 10b2) that run within the area of the rear sides of the solar cells (70, 70b) (Fig. 14).

26. Solar cell assembly according to claim 1, further comprising a diode (101, 20, 10a1, 10b2, 10b3) with a substrate (11, 21) made of a semiconducting material having a first conductivity, a layer (12, 22) formed within a surface area of the substrate or applied onto the surface area of the substrate having a second conductivity, a first metallic contact (13, 23) arranged on the layer having the second conductivity, and a second metallic contact (14, 24) connected beside the first metallic contact at a distance therefrom and electrically isolated by way of a p-n junction, which is in direct contact with the substrate of the protective diode.

**27.** Solar cell assembly according to claim 26,
**characterized in**
**that** a third metallic contact (15, 25) is arranged on the side of the substrate (11, 21) which is opposite relative to the first and second metallic contact (13, 23; 14, 24).

**28.** Solar cell assembly according to claim 26,
**characterized in**
**that** the p-n junction is replaced in the protective diode by a Schottky contact.


**Revendications**

**1.** Ensemble de cellules photovoltaïques, comprenant au moins une première cellule photovoltaïque (30a, 50a, 60, 70) ayant des couches semiconductrices photoactives, entre un contact avant et un contact arrière (34) ainsi qu'au moins une diode de protection (101, 20, 10a1, 10b2, 10b3), discrète, reliée à la cellule, un substrat (11, 21) en un matériau semiconducteur d'un premier type de conductivité, une couche (12) réalisée dans la région de la surface supérieure du substrat ou une couche (22) appliquée sur la région de la surface supérieure, avec une seconde conductivité, un premier contact métallique (13, 23) sur la couche de la seconde conductivité et un second contact métallique (14, 24) installé sur le substrat, des organes de liaison (5a3, 4b7, 40a, 40b, 40c) partant du premier et du second contact métalliques pour le branchement de la diode protectrice,
**caractérisé en ce que**
le second contact (14, 24) est directement en contact avec le substrat (11, 21) de la diode protectrice (121, 10a1, 10b2, 10b3) et à côté du premier contact métallique (13, 23) et à distance de celui-ci, le second contact est relié électriquement au premier contact métallique par l'intermédiaire d'une jonction p/n.

**2.** Ensemble de cellules photovoltaïques selon la revendication 1,
**caractérisé par**
un troisième contact métallique (15, 25) sur le côté du substrat (11, 21), à l'opposé du premier et du second contact (13, 23 ; 14, 24).

**3.** Ensemble de cellules photovoltaïques selon la revendication 2,
**caractérisé en ce que**
le troisième contact métallique (15, 25) est relié à la première cellule photovoltaïque (30a, 50a, 60, 70) ou à une seconde cellule photovoltaïque (30b, 50b, 70b).

**4.** Ensemble de cellules photovoltaïques selon la revendication 1,
**caractérisé en ce que**
les liaisons partant du premier et du second contact métalliques (13, 23, 24 ; 14, 24) relient la première cellule photovoltaïque (30a, 50a, 60, 70) à une seconde cellule photovoltaïque (30b, 50b, 70b).

**5.** Ensemble de cellules photovoltaïques selon les revendications 3 ou 4,
**caractérisé en ce que**
le second contact métallique (14, 24) est relié au dos de la seconde cellule photovoltaïque (30b, 50b, 70b) et le troisième contact métallique (15, 25) est relié au côté avant de la première cellule photovoltaïque (30a, 50a, 70) et réciproquement.

**6.** Ensemble de cellules photovoltaïques selon au moins la revendication 4,
**caractérisé en ce que**
la diode protectrice (101) est branchée selon un montage antiparallèle par rapport à la première cellule photovoltaïque (30a), à partir du second contact métallique (14) par l'intermédiaire de la seconde cellule photovoltaïque (30b).

**7.** Ensemble de cellules photovoltaïques selon au moins la revendication 4,
**caractérisé en ce que**
la diode protectrice (101) est branchée selon un montage antiparallèle par rapport à la première cellule photovoltaïque (30a), à partir du premier contact métallique (14) par l'intermédiaire de la seconde cellule photovoltaïque (30b).

**8.** Ensemble de cellules photovoltaïques selon au moins la revendication 2,
**caractérisé en ce que**

la première et la seconde cellule photovoltaïques (70, 70b) sont reliées par au moins deux diodes protectrices (10a1, 10b2) et le troisième contact métallique (711) de la première diode protectrice (10n2) est relié à la fois au contact du dos de la seconde cellule photovoltaïque (70b) et au second contact métallique de la seconde diode protectrice (10a1) dont le troisième contact métallique est relié au contact frontal de la première cellule photovoltaïque (70) (figures 13, 14).

9. Ensemble de cellules photovoltaïques selon au moins la revendication 2,
**caractérisé en ce qu'**
une liaison (200) partant du troisième contact métallique de la première diode protectrice (10b2) et une liaison (202) partant du second contact métallique de la seconde diode protectrice (10al) dépassent de la face avant des première et seconde cellules photovoltaïques (70, 70b) ou de leurs vitres protectrices (75a, 75c) et elles sont reliées au-delà des vitres protectrices, de préférence par soudage ou brasage (figure 14).

10. Ensemble de cellules photovoltaïques selon la revendication 1 ou 4,
**caractérisé en ce que**
la première cellule photovoltaïque (30a, 50a, 70) et/ou la seconde cellule photovoltaïque (30b, 50b, 70b) a en vue de dessus une forme rectangulaire avec des coins coupés et au moins une diode protectrice (101, 20, 10al, 10b2, 10b3) passe dans la région de l'un des coins coupés.

11. Ensemble de cellules photovoltaïques selon la revendication 10,
**caractérisé par**
plusieurs cellules photovoltaïques branchées en cordon, reliées par des diodes protectrices (101, 20, 10a1, 10b2, 10b3) installées dans la région des coins coupés.

12. Ensemble de cellules photovoltaïques selon la revendication 10 ou 11,
**caractérisé en ce qu'**
en vue de dessus, la diode protectrice (101, 20, 10al, 10b2, 10b3) a une forme géométrique triangulaire.

13. Ensemble de cellules photovoltaïques selon la revendication 10 ou 11,
**caractérisé en ce que**
la diode protectrice (101, 20, 10a1, 10b2, 10b3) a la géométrie d'une colonne de section triangulaire.

14. Ensemble de cellules photovoltaïques selon la revendication 1 ou 12,
**caractérisé en ce que**
la diode protectrice (101, 20, 10a1, 10b2, 10b3) a une surface de base F, de préférence de l'ordre de $0,7\ cm^2 \leq F \leq 1\ cm^2$, notamment de l'ordre de $0,8\ cm^2 \leq F \leq 0,9\ cm^2$.

15. Ensemble de cellules photovoltaïques selon la revendication 10,
**caractérisé par**
une diode protectrice (101, 20, 10al, 10b2, 10b3) de préférence dans chaque coin coupé de la première et/ou de la seconde cellule photovoltaïques (30a 50a, 70 ; 30b, 50b, 70b).

16. Ensemble de cellules photovoltaïques selon la revendication 1,
**caractérisé en ce que**
la première conductivité est de type n et la seconde conductivité de type p ou réciproquement.

17. Ensemble de cellules photovoltaïques selon la revendication 1,
**caractérisé en ce que**
la première cellule photovoltaïque (30a 50a, 70) et/ou la seconde cellule photovoltaïque (30b, 50b, 70b) est une triple cellule, avec de préférence une cellule de fond Ge, de préférence une cellule médiane GaInAs et de préférence une cellule supérieure GaInP.

18. Ensemble de cellules photovoltaïques selon la revendication 1 ou 2,
**caractérisé en ce que**
deux cellules photovoltaïques juxtaposées (70, 70b) sont reliés par deux diodes protectrices (10a1, 10b2),
les cellules photovoltaïques sont des cellules dont la face avant est à conductivité de type n,
l'une des diodes protectrices (10b2) a sur la face frontale une couche d'un second type de conductivité avec une conductivité p et

l'autre cellule protectrice (10al) a, du côté arrière, une couche de seconde conductivité de type n et présente un troisième contact métallique (figure 13).

19. Ensemble de cellules photovoltaïques selon la revendication 8,
    **caractérisé en ce que**
    le contact côté arrière de la première diode protectrice (10b2) est relié à la fois au côté arrière de la seconde cellule photovoltaïque (70b) et aussi au second contact métallique de la seconde diode protectrice (10a1),
    dans le cordon du troisième contact métallique passant sur le côté frontal, la seconde diode protectrice est reliée au contact frontal de la première cellule photovoltaïque (70) et
    le premier contact métallique du cordon passant au dos, de la seconde diode protectrice est relié au côté arrière de la première cellule photovoltaïque (figure 14).

20. Ensemble de cellules photovoltaïques selon la revendication 8,
    **caractérisé en ce que**
    dans les cellules photovoltaïques à jonction p/n, la première diode protectrice a une jonction n/p et la seconde diode protectrice a une jonction p/n.

21. Procédé de branchement d'un cordon de cellules photovoltaïques en utilisant des diodes protectrices selon au moins l'une des revendications précédentes,
    **caractérisé par** les étapes de procédé suivantes :

      - installer les cellules photovoltaïques avec le dos sur un support,
      - relier les contacts côté frontal des cellules photovoltaïques à une première liaison,
      - fixer un ou plusieurs couvercles transparents sur les faces frontales des cellules photovoltaïques,
      - retourner les cellules photovoltaïques,
      - relier les première et seconde cellules photovoltaïques par la première liaison pour former un cordon,
      - introduire des diodes protectrices dans les espaces libres subsistant entre les cellules photovoltaïques,
      - relier les diodes protectrices aux cellules photovoltaïques et
      - relier les cordons ainsi fabriqués, à un support (figure 6).

22. Procédé de montage d'un cordon de cellules photovoltaïques utilisant des diodes protectrices selon au moins l'une des revendications précédentes,
    **caractérisé par** les étapes de procédé suivantes :

      - installer les cellules photovoltaïques avec leur dos sur un support,
      - introduire des diodes protectrices dans les espaces libres entre les cellules photovoltaïques,
      - relier les contacts côté frontal des cellules photovoltaïques au troisième contact (contact côté arrière) passant sur le côté frontal du cordon avec des diodes protectrices,
      - relier les contacts côté frontal des cellules solaires à des premières liaisons,
      - fixer un ou plusieurs couvercles transparents sur les côtés frontaux des cellules solaires et des diodes protectrices,
      - relier les premier et second contacts (contact frontal) passant du côté arrière du cordon des diodes protectrices aux contacts côté arrière de cellules photovoltaïques voisines,
      - retourner les cellules photovoltaïques et
      - relier les cordons ainsi fabriqués à un support (figure 8).

23. Procédé selon la revendication 19,
    **caractérisé en ce qu'**
    on installe les diodes protectrices avec leur troisième contact dans la région côté frontal des cellules photovoltaïques et on branche en série les cellules photovoltaïques voisines par chaque fois au moins une diode protectrice, en branchant en même temps selon un branchement antiparallèle, la diode protectrice par rapport à l'une des cellules photovoltaïques voisines (figure 6).

24. Procédé selon la revendication 21,
    **caractérisé en ce qu'**
    entre deux cellules photovoltaïques voisines on installe deux diodes protectrices dont l'une est reliée par son troisième contact et l'autre par son premier et son second contact dans la région côté frontal des cellules photovoltaïques, les cellules photovoltaïques voisines étant branchées en série par deux diodes protectrices et

les diodes protectrices sont branchées par des contacts passant au dos des cellules photovoltaïques (figure 13).

25. Procédé selon la revendication 21,
**caractérisé en ce que**
les contacts des diodes protectrices (10a1, 10b2) passant dans la région du côté arrière des cellules photovoltaïques (70, 70b) se poursuivent par des secondes liaisons (200, 202) qui sont reliées au-delà du cordon de cellule photovoltaïque et dans sa zone côté frontal (figure 14).

26. Ensemble de cellules photovoltaïques selon la revendication 1,
comprenant en outre une diode 101, 20, 10al, 10b2, 10b3) avec un substrat (11, 21) en une matière semi-conductrice d'un premier type de conductivité, d'une couche (12, 22) réalisée dans la région de la surface supérieure du substrat ou une couche d'un second type de conductivité appliquée dans la région de la surface supérieure, un premier contact métallique (13, 23) sur la couche du second type de conductivité et un second contact métallique (14, 24), à côté du premier contact métallique, à distance de celui-ci, en étant isolé électriquement par rapport à celui-ci par une jonction p/n, le second contact métallique étant directement en contact avec le substrat de la diode protectrice.

27. Ensemble de cellules photovoltaïques selon la revendication 26,
**caractérisé par**
un troisième contact métallique (15, 25) prévu sur le côté du substrat (11, 21) à l'opposé du premier et du second contact métalliques (13, 23 ; 14, 24).

28. Ensemble de cellules photovoltaïques selon la revendication 26,
**caractérisé en ce que**
la jonction p/n de la diode protectrice est remplacée par un contact Schottky.

Fig. 1

Fig. 2

Fig. 3

Fig. 4

| | n - Dotierung |
| | p - Dotierung |
| | n/p- Tunnell - Dotierung |
| | Stromdiagramm |

Fig. 5

| | n - Dotierung |
| | p - Dotierung |
| | n/p- Tunnell - Dotierung |
| | Stromdiagramm |

Fig. 6

**Fig. 7**

**Fig. 8**

n - Dotierung

p - Dotierung

n/p- Tunnell - Dotierung

Stromdiagramm mit
Diode und Widerstand

**Fig. 9**

**Fig. 10**

**Fig. 11**

**Fig. 12**

**Fig. 13**

**Fig. 14**

**Fig. 15**

**Fig. 16**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3826721 A
- US 20020179141 A
- US 4481378 A
- US 6563289 B
- EP 0984496 A
- US 6353176 B
- WO 03012880 A
- US 6034322 B
- US 20030029494 A